# EUROPEAN PATENT APPLICATION

(11) **EP 4 739 032 A1**
(43) Date of publication of application: **06.05.2026**
(21) Application number: 25210378.3
(22) Date of filing: 22.10.2025
(51) Int. Cl.: H10D 84/01, H10D 30/01, H10D 30/43, H10D 30/00, H10D 84/85, H10D 88/00

(54) **STACKED INTEGRATED CIRCUIT DEVICES**

(30) Priority: 30.10.2024 KR 20240151511
(71) Applicant: SAMSUNG ELECTRONICS CO., LTD., Yeongtong-gu Suwon-si, Gyeonggi-do 16677 (KR)
(72) Inventor: MOON, Byungho, 16677 Suwon-si, Gyeonggi-do (KR); HWANG, Donghoon, 16677 Suwon-si, Gyeonggi-do (KR); KIM, Minwoo, 16677 Suwon-si, Gyeonggi-do (KR)
(74) Representative: Kuhnen & Wacker Patent- und Rechtsanwaltsbüro PartG mbB

(57) **Abstract**

A stacked integrated circuit device (1000) includes a plurality of nanosheet stack structures, a gate separator, a lower gate electrode, an upper gate electrode, a lower gate cut structure, an upper gate cut structure, and a coupling gate cut structure. The upper gate electrode extends along a side surface of the coupling gate cut structure and is electrically connected to the lower gate electrode.

## Description

### TECHNICAL FIELD

The present disclosure relates to integrated circuit devices, and more particularly, to a stacked integrated circuit devices.

### BACKGROUND

With the development of electronics technology, down-scaling of integrated circuit devices has been in rapid progress. In addition, to increase the integration density of integrated circuit devices, there has been research into stacked integrated circuit devices.

### SUMMARY

The present disclosure provides stacked integrated circuit devices capable of scaling down.

According to an aspect of the present disclosure, there is provided a stacked integrated circuit device including a plurality of nanosheet stack structures spaced apart from each other in a first direction and a second direction perpendicular to the first direction, the plurality of nanosheet stack structures each including a lower nanosheet stack structure and an upper nanosheet stack structure on the lower nanosheet stack structure; a gate separator between the lower nanosheet stack structure and the upper nanosheet stack structure of each of the plurality of nanosheet stack structures; a lower gate electrode extending around the lower nanosheet stack structure of each of the plurality of nanosheet stack structures; a first upper gate electrode extending around the upper nanosheet stack structure of each of the plurality of nanosheet stack structures; a lower gate cut structure and an upper gate cut structure on the lower gate cut structure, the lower gate cut structure being between a first pair of lower nanosheet stack structures of a first pair of nanosheet stack structures adjacent to each other in the second direction among the plurality of nanosheet stack structures, and the upper gate cut structure being between a first pair of upper nanosheet stack structures of the first pair of nanosheet stack structures; and a coupling gate cut structure between a second pair of nanosheet stack structures adjacent to each other in the second direction among the plurality of nanosheet stack structures, where the first upper gate electrode extends along a side surface of the coupling gate cut structure and is electrically connected to the lower gate electrode.

According to another aspect of the present disclosure, there is provided a stacked integrated circuit device including a plurality of nanosheet stack structures spaced apart from each other in a first direction and a second direction perpendicular to the first direction, the plurality of nanosheet stack structures each including a lower nanosheet stack structure and an upper nanosheet stack structure on the lower nanosheet stack structure; an intermediate insulating layer between the lower nanosheet stack structure and the upper nanosheet stack structure of each of the plurality of nanosheet stack structures; a lower gate electrode extending around the lower nanosheet stack structure of each of the plurality of nanosheet stack structures; a first upper gate electrode extending surrounding the upper nanosheet stack structure of each of the plurality of nanosheet stack structures; a lower gate cut structure and an upper gate cut structure on the lower gate cut structure, the lower gate cut structure being between a first pair of lower nanosheet stack structures of a first pair of nanosheet stack structures adjacent to each other in the second direction among the plurality of nanosheet stack structures, and the upper gate cut structure being between a first pair of upper nanosheet stack structures of the first pair of two nanosheet stack structures; and a coupling gate cut structure a second pair of nanosheet stack structures adjacent to each other in the second direction among the plurality of nanosheet stack structures, where the first upper gate electrode includes a connection extension and a first protrusion, where the connection extension extends along a side surface of the coupling gate cut structure and is electrically connected to the lower gate electrode, and where the first protrusion extends from a portion of the first upper gate electrode that overlaps the intermediate insulating layer and the lower gate cut structure in a third direction that is perpendicular to the first direction and the second direction.

According to a further aspect of the present disclosure, there is provided a stacked integrated circuit device including a plurality of nanosheet stack structures spaced apart from each other in a first direction and a second direction perpendicular to the first direction, the plurality of nanosheet stack structures each including a lower nanosheet stack structure and an upper nanosheet stack structure on the lower nanosheet stack structure, the lower nanosheet stack structure including a plurality of lower nanosheets spaced apart from each other in a third direction that is perpendicular to the first direction and the second direction, and the upper nanosheet stack structure including a plurality of upper nanosheets spaced apart from each other in the third direction; a gate separator between the lower nanosheet stack structure and the upper nanosheet stack structure of each of the plurality of nanosheet stack structures; a lower gate electrode extending around the lower nanosheet stack structure of each of the plurality of nanosheet stack structures; an upper gate electrode extending around the upper nanosheet stack structure of each of the plurality of nanosheet stack structures; a lower gate cut structure and an upper gate cut structure on the lower gate cut structure, the lower gate cut structure being between a first pair of lower nanosheet stack structures of a first pair of nanosheet stack structures adjacent to each other in the second direction among the plurality of nanosheet stack structures, and the upper gate cut structure being between a first pair of upper nanosheet stack structures of the first pair of nanosheet stack structures; and a coupling gate cut structure between a second pair of nanosheet stack structures adjacent to each other in the second direction among the plurality of nanosheet stack structures, where the upper gate electrode includes a connection extension and a protrusion, the connection extension extending along a side surface of the coupling gate cut structure and being electrically connected to the lower gate electrode, the protrusion extending from a portion of the upper gate electrode overlapping the gate separator and a first portion of a top surface of the lower gate cut structure in the third direction, and where a width of each of the plurality of lower nanosheets in the second direction is greater than a width of each of the plurality of upper nanosheets in the second direction.

### BRIEF DESCRIPTION OF THE DRAWINGS

Embodiments will be more clearly understood from the following detailed description taken in conjunction with the accompanying drawings in which:
FIG. 1 is an equivalent circuit diagram of a stacked integrated circuit device according to embodiments;
FIG. 2 is a schematic layout diagram illustrating a method of manufacturing a stacked integrated circuit device, according to embodiments;
FIGS. 3A, 3B, 3C, 4A, 4B, 4C, 5A, 5B, 5C, 6A, 6B, 6C, 7A, 7B, 7C, 8A, 8B, 8C, 9A, 9B, 9C, 10A, 10B, 10C, 11A, 11B, 11C, 12A, 12B, 12C, 13A, 13B, 13C, 14A, 14B, 14C, 15A, 15B, and 15C are cross-sectional views illustrating a method of manufacturing a stacked integrated circuit device, according to embodiments;
FIGS. 16A, 16B, and 16C are cross-sectional views illustrating a stacked integrated circuit device according to embodiments;
FIG. 17 is a cross-sectional view illustrating a stacked integrated circuit device according to embodiments; and
FIG. 18 is a cross-sectional view illustrating a stacked integrated circuit device according to embodiments.

### DETAILED DESCRIPTION

To clarify the present disclosure, the same elements or equivalents are referred to by the same reference numerals throughout the specification. Further, since sizes and thicknesses of constituent members shown in the accompanying drawings are arbitrarily given for better understanding and ease of description, the present disclosure is not limited to the illustrated sizes and thicknesses. In the drawings, the thickness of layers, films, panels, regions, etc., are exaggerated for clarity. In the drawings, for better understanding and ease of description, thicknesses of some layers and areas are excessively displayed.

It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, spatially relative terms, such as "beneath," "below," "lower," "above," "upper," and the like, may be used herein for ease of description to describe one element's or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations), and the spatially relative descriptors used herein may be interpreted accordingly.

In addition, unless explicitly described to the contrary, the word "comprises", and variations such as "comprises" or "comprising", will be understood to imply the inclusion of stated elements but not the exclusion of any other elements. As used herein, the singular forms "a," "an" and "the" are intended to include the plural forms as well, unless the context clearly indicates otherwise. The term "and/or" includes any and all combinations of one or more of the associated listed items. The term "connected" may be used herein to refer to a physical and/or electrical connection and may refer to a direct or indirect physical and/or electrical connection. The term "exposed" may be used to define a relationship between particular layers or surfaces, but it does not require the layer or surface to be free of other elements or layers thereon in the completed device. Components or layers described with reference to "overlap" in a particular direction may be at least partially obstructed by one another when viewed along a line extending in the particular direction or in a plane perpendicular to the particular direction. The terms "first," "second," etc. may be used herein to merely distinguish one component, element, etc., from another.

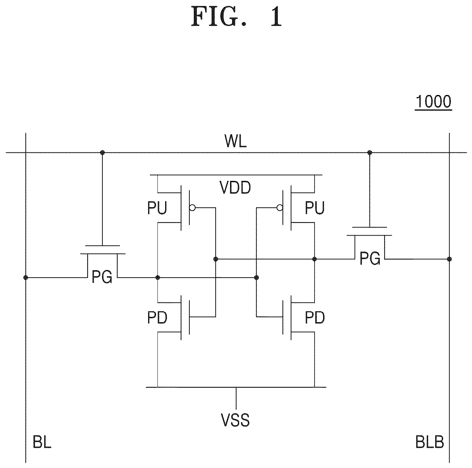

FIG. 1 is an equivalent circuit diagram of a stacked integrated circuit device according to embodiments.

Referring to FIG. 1, a stacked integrated circuit device 1000 may include a plurality of transistors. The stacked integrated circuit device 1000 may include a pair of cross-coupled transistors. Here, being "cross-coupled" may mean that two similar devices are connected in parallel to each other and that the output of each device is provided to the input of the other device. For example, cross-coupled negative AND (NAND) gates may form a set-reset (SR) flip-flop or latch. In some embodiments, at least some of the transistors of the stacked integrated circuit device 1000 may form static random-access memory (SRAM) but are not limited thereto. SRAM may use a latch circuit to store at least one bit. FIG. 1 illustrates an equivalent circuit of SRAM included in the stacked integrated circuit device 1000.

The SRAM may include six metal-oxide semiconductor field-effect transistors (MOSFETs). The six MOSFETs may include two pull-up transistors PU, two pull-down transistors PD, and two pass-gate transistors PG. A pull-up transistor PU and a pull-down transistor PD corresponding thereto may form an inverter, and the two pull-up transistors PU and two pull-down transistors PD may be cross-connected to each other. For example, the gate of the pull-up transistor PU of one inverter and the gate of the pull-down transistor PD of the inverter may be respectively connected to the source of the pull-up transistor PU of the other inverter and the source of the pull-down transistor PD of the other inverter. Two pass-gate transistors PG may control access during read and write operations performed on a memory cell that includes two inverters cross-connected to each other. For example, the source of one pass-gate transistor PG may be electrically connected to the respective sources of a pull-up transistor PU and a pull-down transistor PD of one inverter and the respective gates of a pull-down transistor PD and a pull-up transistor PU of the other inverter, the gate of the pass-gate transistor PG may be electrically connected to a word line WL, and the drain of the pass-gate transistor PG may be electrically connected to a bit line BL. The source of the other pass-gate transistor PG may be electrically connected to the respective gates of the pull-up transistor PU and the pull-down transistor PD of one inverter and the respective sources of the pull-down transistor PD and the pull-up transistor PU of the other inverter, the gate of the pass-gate transistor PG may be electrically connected to the word line WL, and the drain of the pass-gate transistor PG may be electrically connected to a complementary bit line BLB. The drain of a pull-up transistor PU may be connected to a power supply VDD, and the drain of a pull-down transistor PD may be connected to ground VSS.

During a read operation, the word line WL may be set to be high (e.g., logic state "1") so that two pass-gate transistors PG activate access to a memory cell. When the word line WL is activated, a value (e.g., "0" or "1") of the memory cell may be read through the bit line BL and/or the complementary bit line BLB. For example, when the logic state "1" is stored in the memory cell and the word line WL turns the two pass-gate transistors PG on, the bit line BL may read "1" and the complementary bit line BLB may read "0". During a write operation, for example, when a command is executed to write "1" to the memory cell, the word line WL may be set to be high such that the two pass-gate transistors PG are turned on and the bit line BL may be set to a high voltage to override a value "0" stored in the memory cell. Accordingly, at least one bit may be stored in the SRAM and accessed.

Each of two pull-down transistors PD may be an n-type MOS (NMOS) transistor and each of two pull-up transistors PU may be a p-type MOS (PMOS) transistor. Two pass-gate transistors PG may both be NMOS transistors or PMOS transistors.

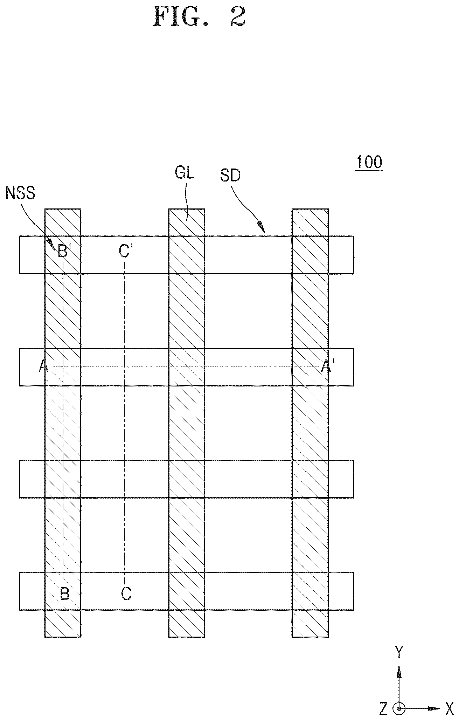

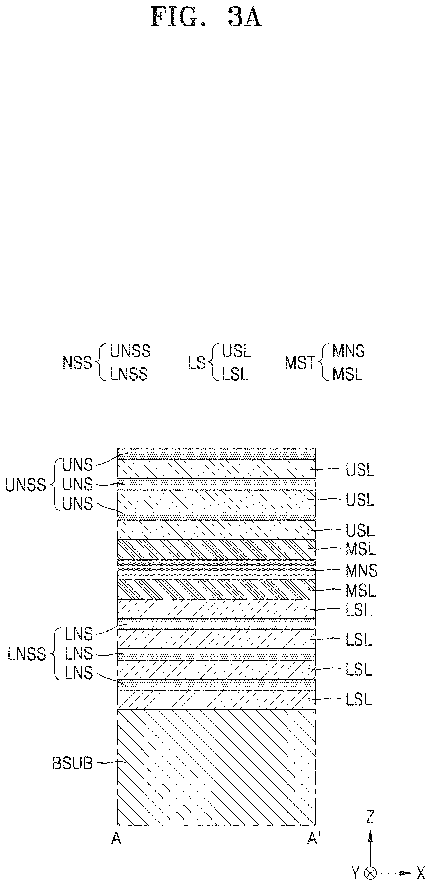

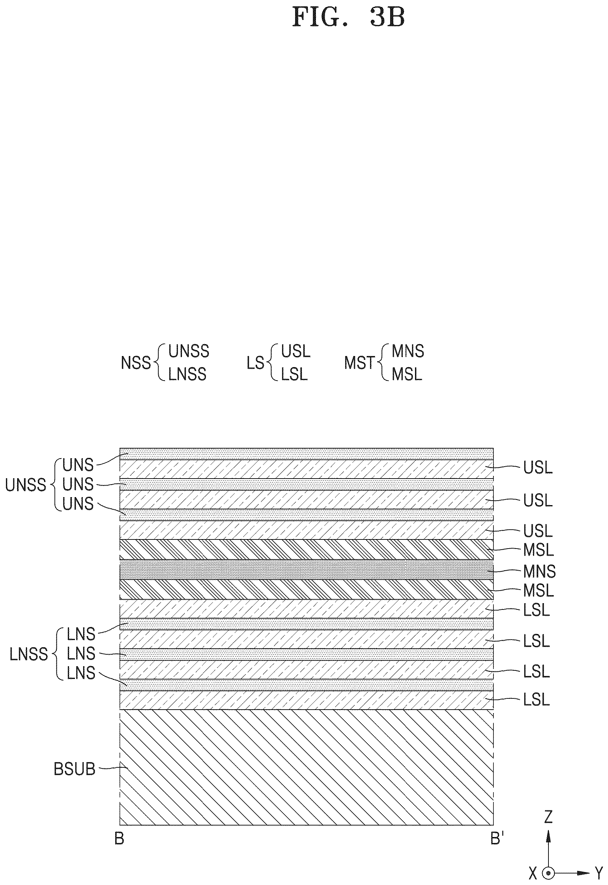

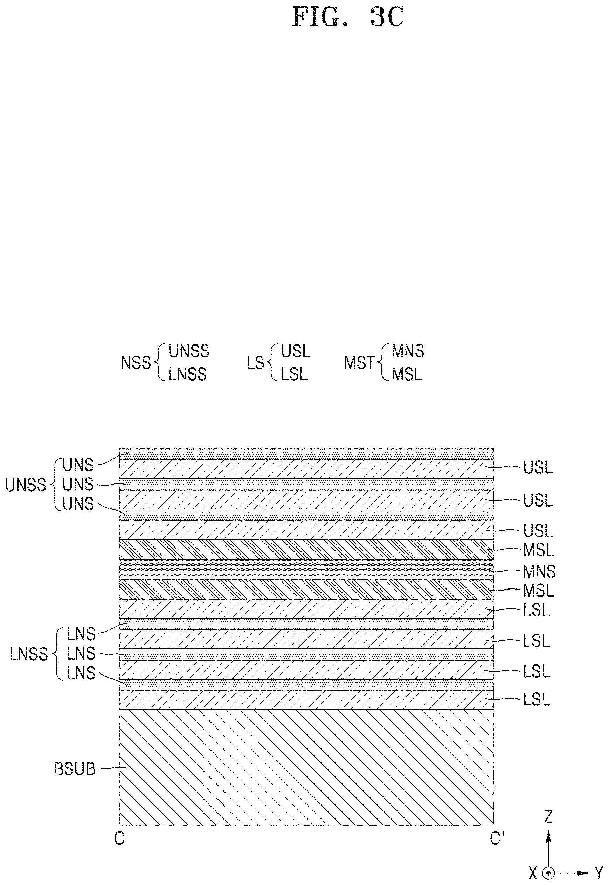

FIG. 2 is a schematic layout diagram illustrating a method of manufacturing a stacked integrated circuit device, according to embodiments. FIGS. 3A to 15C are cross-sectional views illustrating a method of manufacturing a stacked integrated circuit device, according to embodiments. In detail, FIGS. 3A, 4A, 5A, 6A, 7A, 8A, 9A, 10A, 11A, 12A, 13A, 14A, and 15A are cross-sectional views taken along a position corresponding to line A-A' in FIG. 2. FIGS. 3B, 4B, 5B, 6B, 7B, 8B, 9B, 10B, 11B, 12B, 13B, 14B, and 15B are cross-sectional views taken along a position corresponding to line B-B' in FIG. 2. FIGS. 3C, 4C, 5C, 6C, 7C, 8C, 9C, 10C, 11C, 12C, 13C, 14C, and 15C are cross-sectional views taken along a position corresponding to line C-C' in FIG. 2.

Referring to FIG. 2, a stacked integrated circuit device 100 may include a plurality of nanosheet stack structures NSS, a plurality of gate electrodes GL, and a plurality of source/drain regions SD. The nanosheet stack structures NSS may be arranged in rows and columns in a first horizontal direction (an X direction) and a second horizontal direction (a Y direction). The first horizontal direction (the X direction) may be perpendicular to the second horizontal direction (the Y direction). The gate electrodes GL may be spaced apart from each other in the first horizontal direction (the X direction) and may extend in the second horizontal direction (the Y direction). In some embodiments, a source/drain region SD may be between a pair of nanosheet stack structures NSS adjacent to each other in the first horizontal direction (the X direction) among the plurality of nanosheet stack structures NSS. For example, the plurality of nanosheet stack structures NSS may be arranged alternately with the plurality of source/drain regions SD in the first horizontal direction (the X direction).

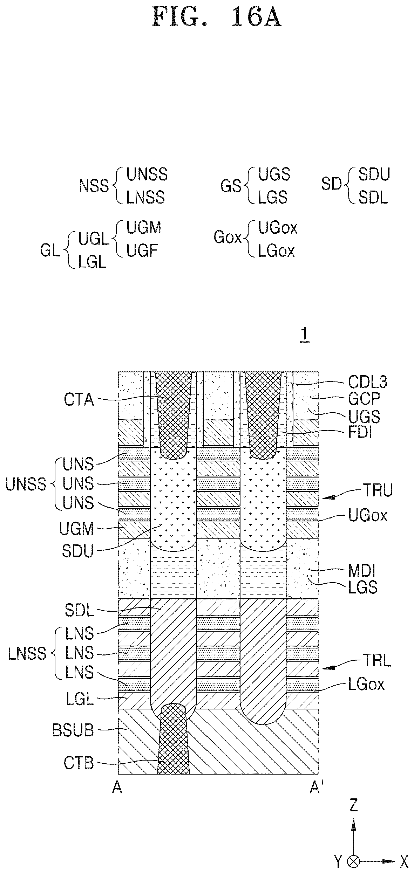

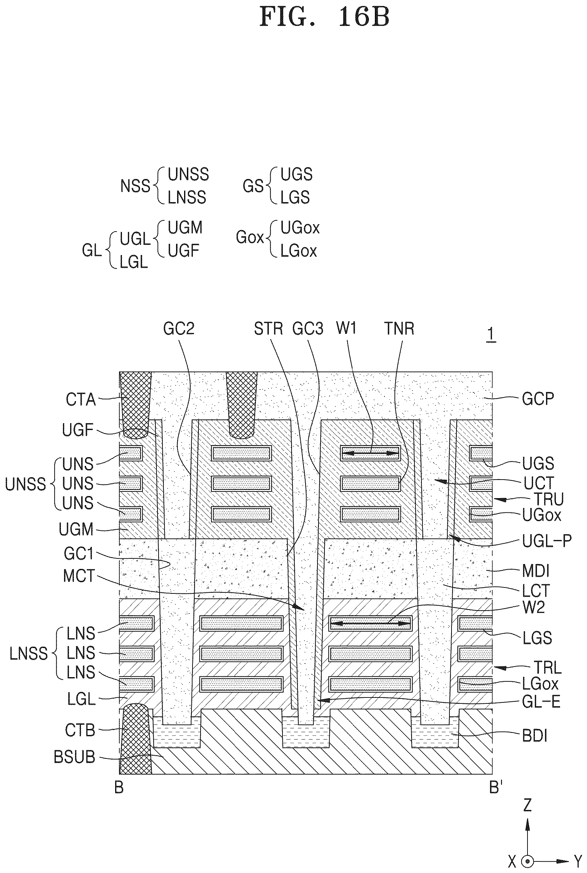

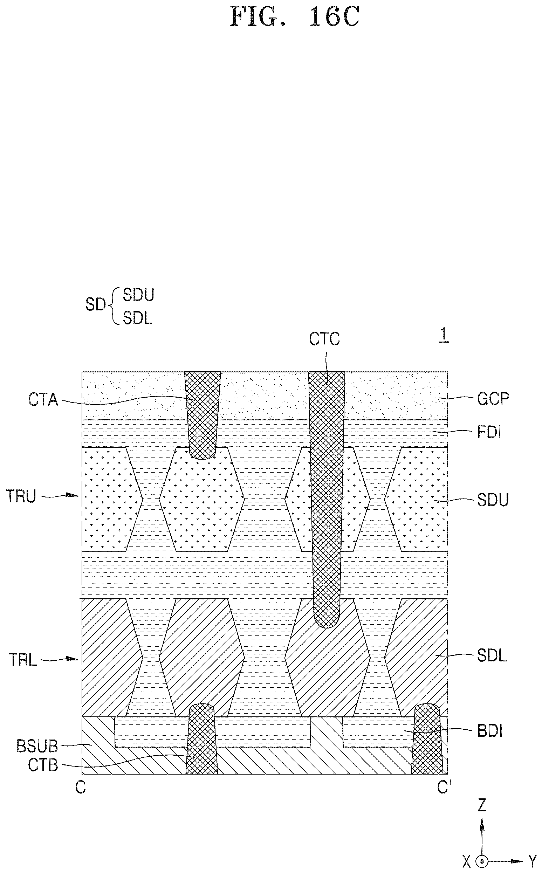

The nanosheet stack structures NSS may include a lower nanosheet stack structure LNSS (in FIGS. 16A and 16B) and an upper nanosheet stack structure UNSS (in FIGS. 16A and 16B), which are spaced apart from each other in a vertical direction (a Z direction). A source/drain region SD may be arranged at each of opposite sides of the nanosheet stack structures NSS in the first horizontal direction (the X direction). The source/drain region SD may include a lower source/drain region SDL (in FIG. 16C) and an upper source/drain region SDU (in FIG. 16C), which are spaced apart from each other in the vertical direction (the Z direction). The lower source/drain region SDL may be connected to a plurality of lower nanosheets LNS (in FIGS. 16A and 16B) included in lower nanosheet stack structures LNSS adjacent to each other in the first horizontal direction (the X direction). The upper source/drain region SDU may be connected to a plurality of upper nanosheets UNS (in FIGS. 16A and 16B) included in upper nanosheet stack structures UNSS adjacent to each other in the first horizontal direction (the X direction).

The stacked integrated circuit device 100 may include a plurality of logic cells. The plurality of logic cells may be configured in various ways, including a plurality of circuit elements, such as transistors and registers. At least some of the plurality of logic cells may include a pair of cross-coupled transistors. Each of the plurality of logic cells may constitute or correspond to, for example, an AND gate, a NAND gate, an OR gate, a NOR gate, an exclusive OR (XOR) gate, an exclusive NOR (XNOR) gate, an inverter (INV), an adder (ADD), a buffer (BUF), a delay (DLY), a filter (FIL), a multiplexer (MXT/MXIT), an OR/AND/inverter (OAI) gate, an AND/OR (AO) gate, an AND/OR/inverter (AOI) gate, a D flip-flop, a reset flip-flop, a master-slave flip-flop, or a latch. Each logic cell may constitute a standard cell which performs a logical function.

Referring to FIGS. 3A to 3C, a plurality of lower sacrificial layers LSL and a plurality of lower nanosheets LNS are alternately stacked on a base substrate layer BSUB. For example, one of the lower nanosheets LNS may be between two lower sacrificial layers LSL adjacent to each other in the vertical direction (the Z direction). The plurality of lower nanosheets LNS may form a lower nanosheet stack structure LNSS. An intermediate structure MST may be formed on the plurality of lower sacrificial layers LSL and the lower nanosheets LNS. Thereafter, a plurality of upper sacrificial layers USL and a plurality of upper nanosheets UNS may be alternately stacked on the intermediate structure MST. In some embodiments, the intermediate structure MST may include a pair of intermediate sacrificial layers MSL spaced apart from each other in the vertical direction (the Z direction) and an intermediate nanosheet MNS between the intermediate sacrificial layers MSL. The upper nanosheets UNS may form an upper nanosheet stack structure UNSS. The intermediate structure MST may be between the lower nanosheet stack structure LNSS and the upper nanosheet stack structure UNSS. The lower nanosheet stack structure LNSS and the upper nanosheet stack structure UNSS may be collectively referred to as a nanosheet stack structure NSS. The lower sacrificial layers LSL and the upper sacrificial layers USL may be collectively referred to as sacrificial layers LS. In some embodiments, the intermediate nanosheet MNS may be thicker than each of the lower nanosheets LNS and the upper nanosheets UNS.

In some embodiments, the number of lower nanosheets LNS forming the lower nanosheet stack structure LNSS may be different from the number of upper nanosheets UNS forming the upper nanosheet stack structure UNSS. For example, in the lower nanosheet stack structure LNSS and the upper nanosheet stack structure UNSS, the number of nanosheets forming a nanosheet stack structure constituting a PMOS transistor may be greater than the number of nanosheets forming a nanosheet stack structure constituting an NMOS transistor. For example, when the lower nanosheet stack structure LNSS is a PMOS transistor and the upper nanosheet stack structure UNSS is an NMOS transistor, the number of lower nanosheets LNS may be greater than the number of upper nanosheets UNS.

In some embodiments, the lower nanosheets LNS and the upper nanosheets UNS may include the same material as the base substrate layer BSUB or of a material that has a similar etching characteristic to the base substrate layer BSUB. The base substrate layer BSUB may include a semiconductor material, such as silicon (Si) or germanium (Ge), or a compound semiconductor material, such as silicon germanium (SiGe), silicon carbide (SiC), gallium arsenide (GaAs), indium arsenide (InAs), or indium phosphide (InP). In some embodiments, the base substrate layer BSUB may include at least one of a Group III-V material and a Group IV material. The Group III-V materials may include a binary, ternary, or quaternary compound semiconductor material including at least one Group III element and at least one Group V element. The base substrate layer BSUB may include a conductive region, e.g., an impurity-doped well or an impurity-doped structure. In some embodiments, the base substrate layer BSUB, the lower nanosheets LNS, and the upper nanosheets UNS may each include a semiconductor material, such as Si or Ge.

In some embodiments, the lower sacrificial layers LSL may include the same material as the upper sacrificial layers USL or may include a material that has a similar etching characteristic to the upper sacrificial layers USL. The lower sacrificial layers LSL and the upper sacrificial layers USL may include a material that has an etch selectivity with respect to the lower nanosheets LNS and the upper nanosheets UNS. For example, each of the lower sacrificial layers LSL and the upper sacrificial layers USL may include a compound semiconductor material such as SiGe.

The pair of intermediate sacrificial layers MSL may include a material that has an etch selectivity with respect to the lower nanosheets LNS, the upper nanosheets UNS, the lower sacrificial layers LSL, and the upper sacrificial layers USL. For example, while each of the intermediate sacrificial layers MSL, the lower sacrificial layers LSL, and the upper sacrificial layers USL may include a compound semiconductor material such as SiGe, the concentration of Ge atoms among the Si atoms and Ge atoms of each of the intermediate sacrificial layers MSL may be different from the concentration of Ge atoms among the Si atoms and Ge atoms of each of the lower sacrificial layers LSL and the upper sacrificial layers USL. In some embodiments, the intermediate nanosheet MNS may include a material that has an etch selectivity with respect to the lower nanosheets LNS, the upper nanosheets UNS, the lower sacrificial layers LSL, and the upper sacrificial layers USL, but the embodiments are not limited thereto. For example, the intermediate nanosheet MNS may include a material, which has an etch selectivity with respect to the lower sacrificial layers LSL and the upper sacrificial layers USL and is the same as the material of the lower nanosheets LNS and the upper nanosheets UNS or has a similar etching characteristic to lower nanosheets LNS and the upper nanosheets UNS.

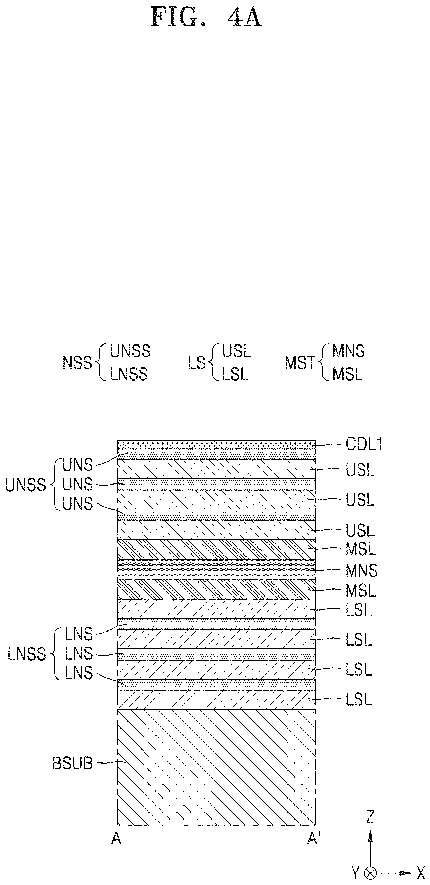

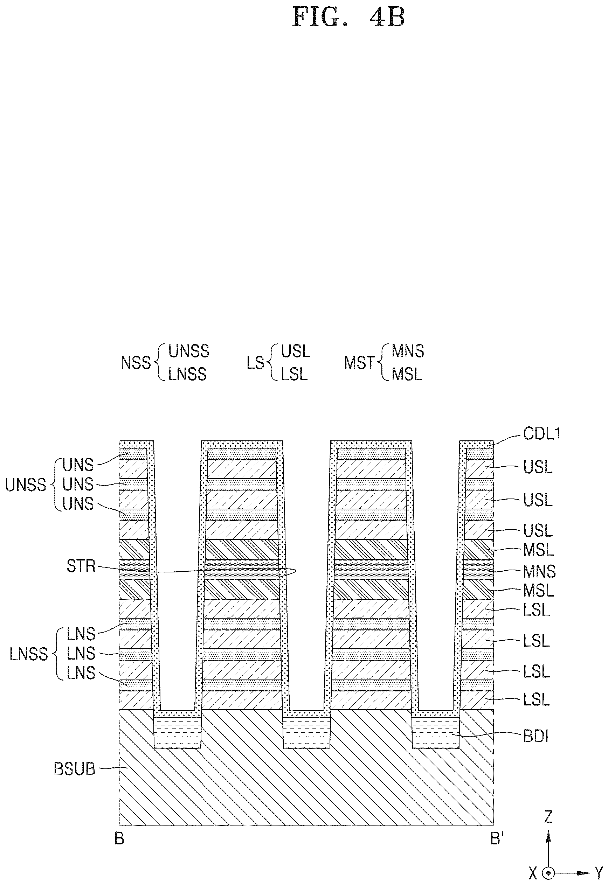

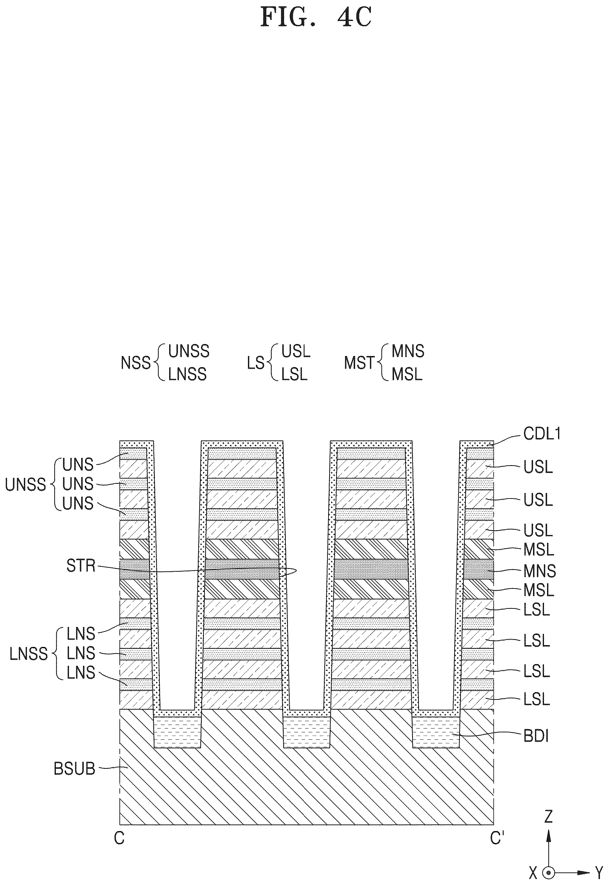

Referring to FIGS. 4A to 4C, an isolation recess STR may be formed by patterning the nanosheet stack structure NSS, which includes the lower nanosheet stack structure LNSS and the upper nanosheet stack structure UNSS, and the intermediate structure MST. Each of the nanosheet stack structure NSS and the intermediate structure MST may be patterned into a plurality of nanosheet stack structures NSS or a plurality of intermediate structures MST, which are arranged in rows and columns in the first horizontal direction (the X direction) and the second horizontal direction (the Y direction). In the process of patterning the nanosheet stack structure NSS and the intermediate structure MST, an upper portion of the base substrate layer BSUB at least partially exposed between the multiple portions resulting from the patterning may also be removed. For example, the isolation recess STR may extend from the top of the nanosheet stack structure NSS into the base substrate layer BSUB.

Thereafter, a lower insulating layer BDI may be formed to fill at least a portion of a space from which the upper portion of the base substrate layer BSUB has been removed. The lower insulating layer BDI may include an insulating material. The lower insulating layer BDI may include oxide. For example, the lower insulating layer BDI may include a material including at least one selected from the group consisting of silicon oxide, silicon nitride, and silicon oxynitride. The lower insulating layer BDI may include a single layer including one type of insulating film, a double layer including two types of insulating films, or a multi-layer including at least three types of insulating films. For example, the lower insulating layer BDI may include two types of different insulating films. For example, the lower insulating layer BDI may include a silicon oxide film and a silicon nitride film. For example, the lower insulating layer BDI may include three layers including a silicon oxide film, a silicon nitride film, and a silicon oxide film. The lower insulating layer BDI may be referred to as an isolation film. Each of upper portions of the base substrate layer BSUB, which are defined by the lower insulating layer BDI, may be referred to as a fin-type active region.

A first insulating material layer CDL1 may be formed to cover or at least partially overlap the surface of each of the lower insulating layer BDI, the nanosheet structures NSS, and the intermediate structures MST. The first insulating material layer CDL1 may be formed to conformally cover or overlap the surfaces of the lower insulating layer BDI, the nanosheet stack structures NSS, and the intermediate structures MST. The first insulating material layer CDL1 may include an insulating material. In some embodiments, the first insulating material layer CDL1 may include oxide.

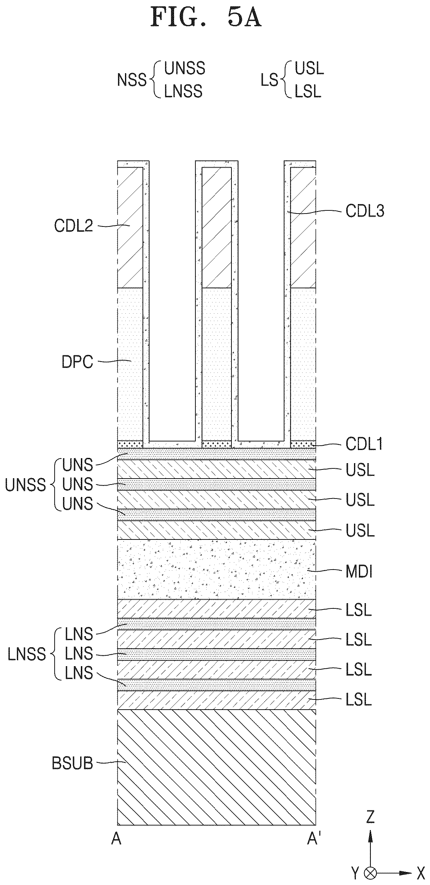

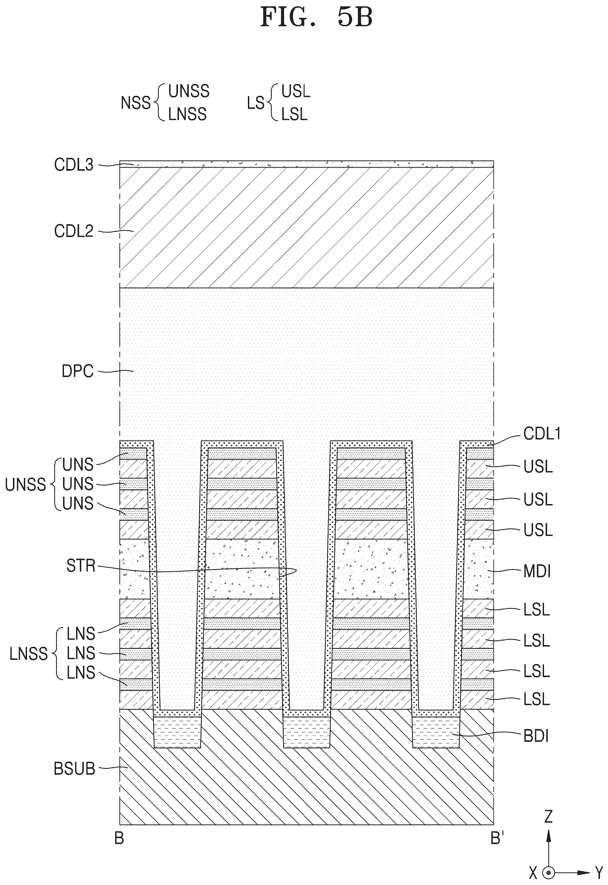

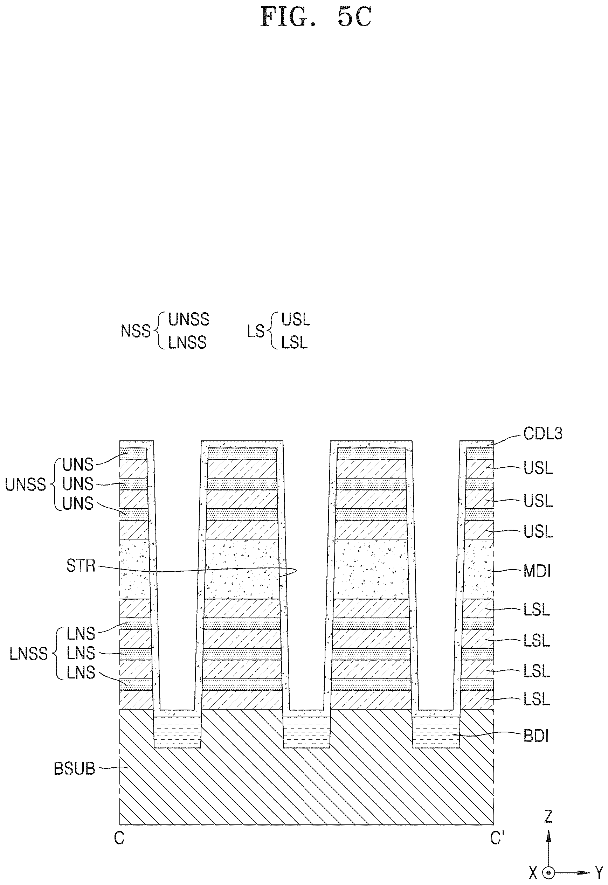

Referring to FIGS. 5A to 5C together with FIGS. 4A to 4C, stack structures of a plurality of dummy gate layers DPC and a plurality of second insulating material layers CDL2 may be formed on the first insulating material layer CDL1. The stack structures of the dummy gate layers DPC and the second insulating material layers CDL2 may be formed by forming a preliminary conductive layer on the first insulating material layer CDL1 and a preliminary insulating layer covering or at least partially overlapping the preliminary conductive layer and patterning the preliminary conductive layer and the preliminary insulating layer. In the process of patterning the preliminary conductive layer and the preliminary insulating layer, portions of the first insulating material layer CDL1 at least partially exposed between patterned results may also be removed. For example, a nanosheet stack structure NSS, an intermediate structure MST, and the lower insulating layer BDI may be exposed between the stack structures of the dummy gate layers DPC and the second insulating material layers CDL2 at bottom or lower portions of the stack structures. The dummy gate layers DPC may include polysilicon, and the second insulating material layers CDL2 may include silicon nitride.

After the stack structures of the dummy gate layers DPC and the second insulating material layers CDL2 are formed, each of the intermediate structures MST, which includes a pair of intermediate sacrificial layers MSL and the intermediate nanosheet MNS between the intermediate sacrificial layers MSL, may be removed, and an intermediate insulating layer MDI may be formed to at least partially fill a space from which the intermediate structure MST has been removed. The intermediate insulating layer MDI may include nitride. For example, the intermediate insulating layer MDI may include silicon nitride or silicon oxynitride. The intermediate insulating layer MDI may be referred to as a gate separator.

A third insulating material layer CDL3 may be formed to cover or at least partially overlap an exposed surface of each of the dummy gate layers DPC, the second insulating material layers CDL2, the nanosheet structures NSS, the intermediate insulating layer MDI, and the lower insulating layer BDI. For example, the third insulating material layer CDL3 may be formed to conformally cover or overlap the exposed surfaces of the dummy gate layers DPC, the second insulating material layers CDL2, the nanosheet structures NSS, the intermediate insulating layer MDI, and the lower insulating layer BDI. The third insulating material layer CDL3 may include, but is not limited to, silicon nitride. In some embodiments, the third insulating material layer CDL3 may have a stack structure of an oxide layer and a nitride layer.

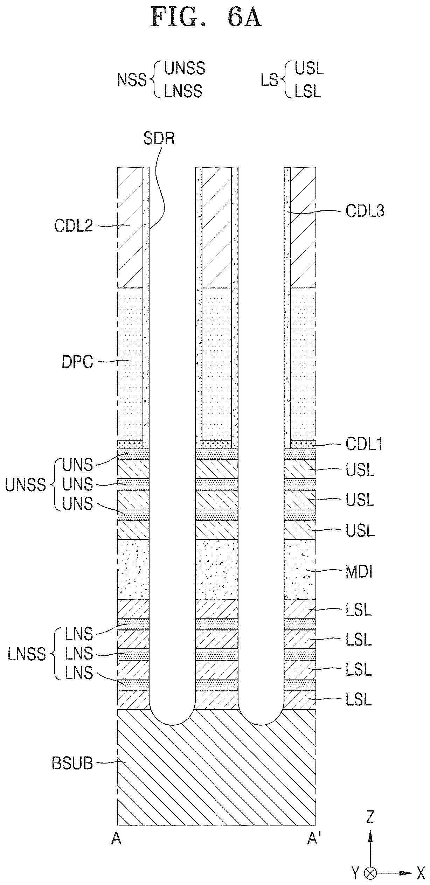

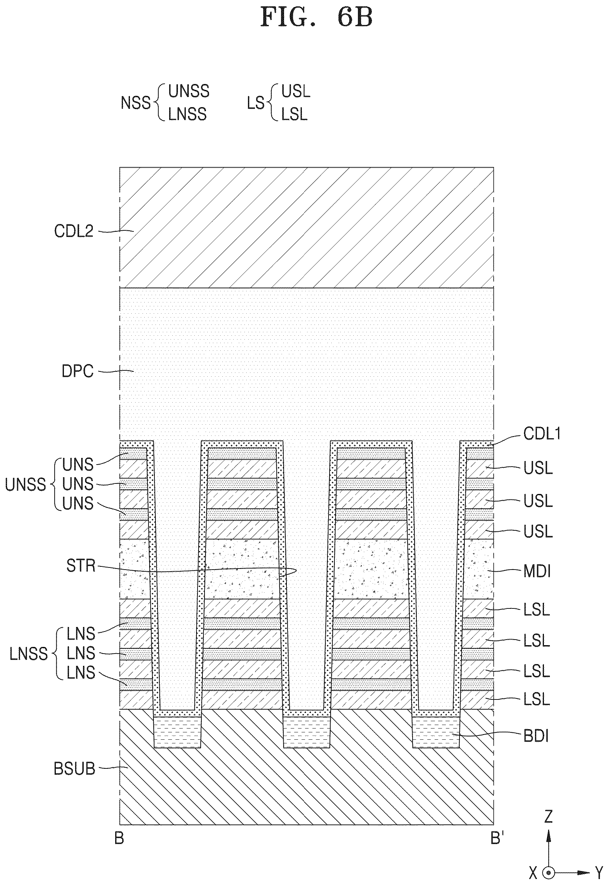

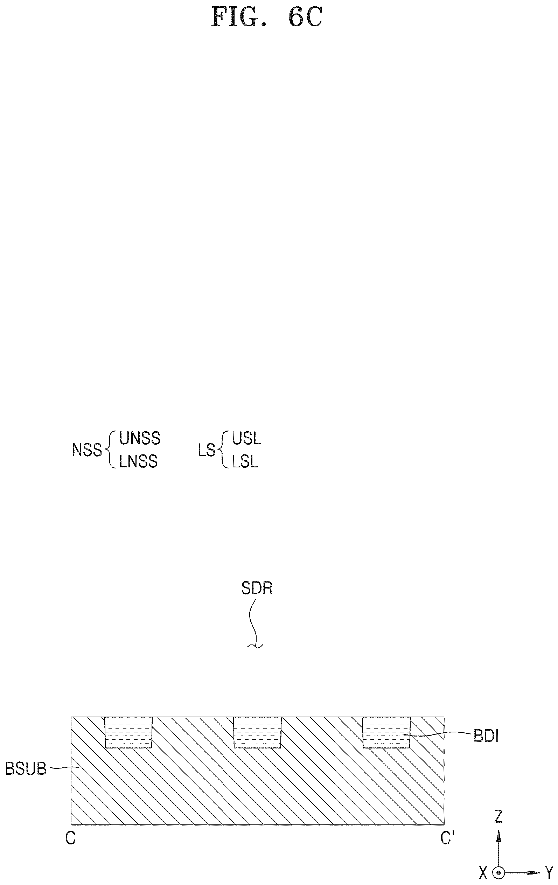

Referring to FIGS. 6A to 6C, a plurality of source/drain recesses SDR may be formed by removing portions of the nanosheet structures NSS and portions of the intermediate insulating layer MDI through spaces between the stack structures of the dummy gate layers DPC and the second insulating material layers CDL2. For example, the source/drain recesses SDR may be formed through an anisotropic etching process. In the process of forming the source/drain recesses SDR, a portion of the third insulating material layer CDL3, which covers or at least partially overlaps the top surface of any one of the second insulating material layers CDL2, the nanosheet structures NSS, and the lower insulating layer BDI, may also be removed. The base substrate layer BSUB and the lower insulating layer BDI may be exposed at the bottom of each of the source/drain recesses SDR. In some embodiments, in the process of forming the source/drain recesses SDR, an upper portion of the base substrate layer BSUB below a space between the stack structures of the dummy gate layers DPC and the second insulating material layers CDL2 may also be removed. For example, the source/drain recesses SDR may extend into the base substrate layer BSUB through the top end of the base substrate layer BSUB.

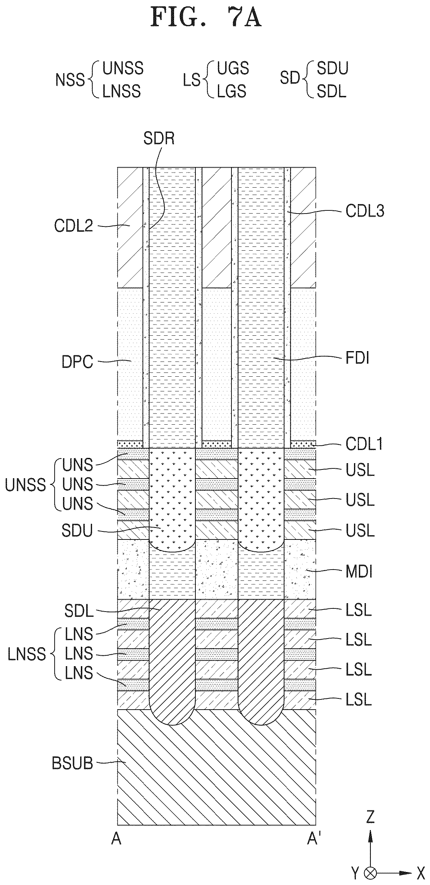

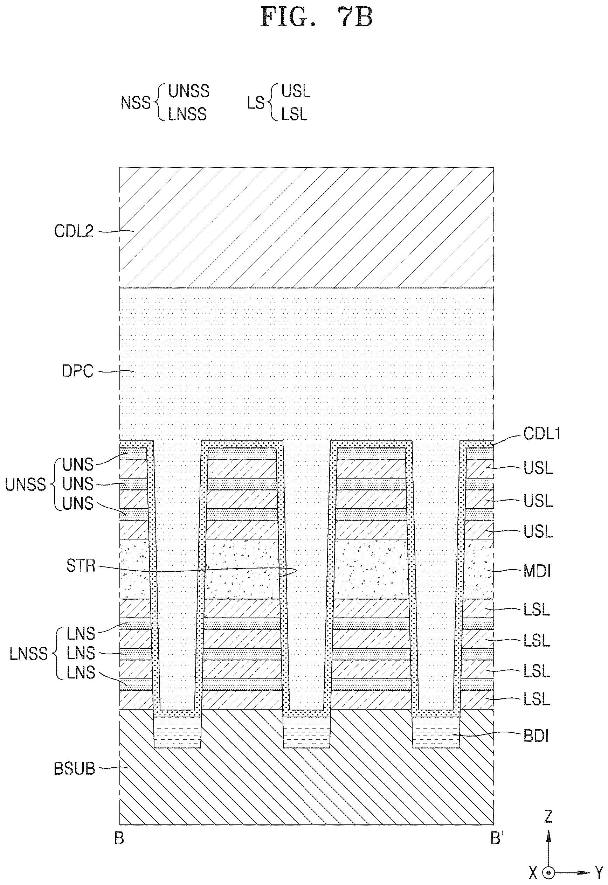

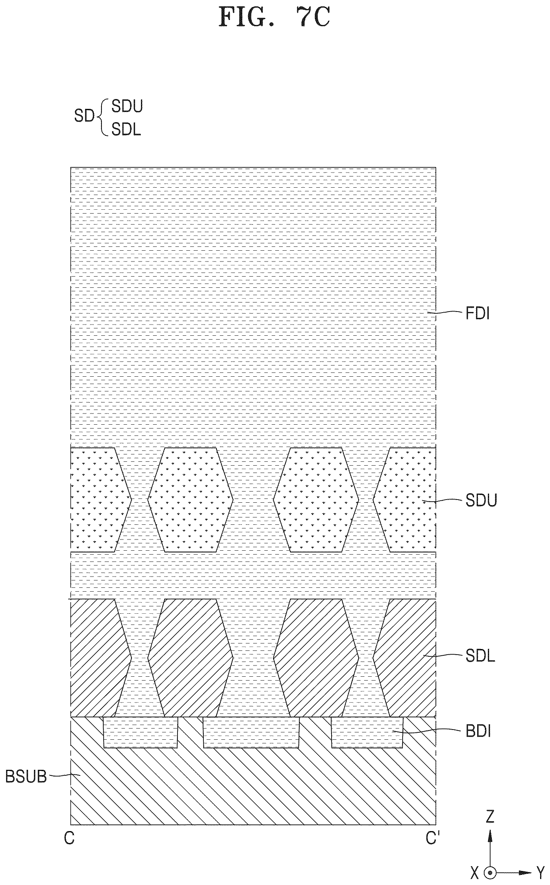

Referring to FIGS. 7A to 7C, a plurality of source/drain regions SD may be formed by epitaxial growth from the surfaces of the nanosheet structures NSS and the base substrate layer BSUB, which are exposed by the source/drain recesses SDR. Each of the source/drain regions SD may include a lower source/drain region SDL and an upper source/drain region SDU. After the source/drain regions SD are formed, an interlayer insulating layer FDI may be formed to fill each of the source/drain recesses SDR. The interlayer insulating layer FDI may be formed to fill all the spaces between the stack structures of the dummy gate layers DPC and the second insulating material layers CDL2.

In some embodiments, after the lower source/drain region SDL is formed, a portion of the interlayer insulating layer FDI may be formed to surround or extend around the lower source/drain region SDL and at least partially fill a lower portion of each source/drain recess SDR. Thereafter, the upper source/drain region SDU may be formed, and then the other portion of the interlayer insulating layer FDI may be formed to surround or extend around the upper source/drain region SDU and at least partially fill an upper portion of the source/drain recess SDR. In some embodiments, after the lower source/drain region SDL and the upper source/drain region SDU are formed, the interlayer insulating layer FDI may be formed to surround or extend around the lower source/drain region SDL and the upper source/drain region SDU and at least partially fill the source/drain recess SDR.

Each of the source/drain regions SD may include an epitaxially grown Si layer, an epitaxially grown SiC layer, or an embedded SiGe structure including a plurality of epitaxially grown SiGe layers. The lower source/drain region SDL may be formed by epitaxial growth from the surface of each of the base substrate layer BSUB and the lower nanosheets LNS of the lower nanosheet stack structure LNSS. The upper source/drain region SDU may be formed by epitaxial growth from the surface of each of the upper nanosheets UNS of the upper nanosheet stack structure UNSS. For example, the interlayer insulating layer FDI may include silicon oxide or an insulating material that has a lower permittivity than silicon oxide. In some embodiments, the interlayer insulating layer FDI may include a tetraethyl orthosilicate (TEOS) film or an ultra-low k (ULK) film that has an ultra low dielectric constant of about 2.2 to about 2.4. The ULK film may include an SiOC film or an SiCOH film.

The lower source/drain region SDL may include impurities of a different conductivity type than the upper source/drain region SDU. The lower nanosheets LNS in contact with the lower source/drain region SDL may include impurities of a different conductivity type than the upper nanosheets UNS in contact with the upper source/drain region SDU. In some embodiments, an NMOS transistor may be formed in the upper source/drain region SDU and the upper nanosheets UNS, and a PMOS semiconductor may be formed in the lower source/drain region SDL and lower nanosheets LNS. For example, the lower source/drain region SDL may include p-type impurities, and the upper source/drain region SDU may include n-type impurities. For example, each of the lower nanosheets LNS may include n-type impurities, and each of the upper nanosheets UNS may include p-type impurities. In some embodiments, a PMOS transistor may be formed in the upper source/drain region SDU and the upper nanosheets UNS, and an NMOS transistor may be formed in the lower source/drain region SDL and the lower nanosheets LNS. For example, the lower source/drain region SDL may include n-type impurities, and the upper source/drain region SDU may include p-type impurities. For example, each of the lower nanosheets LNS may include p-type impurities, and each of the upper nanosheets UNS may include n-type impurities.

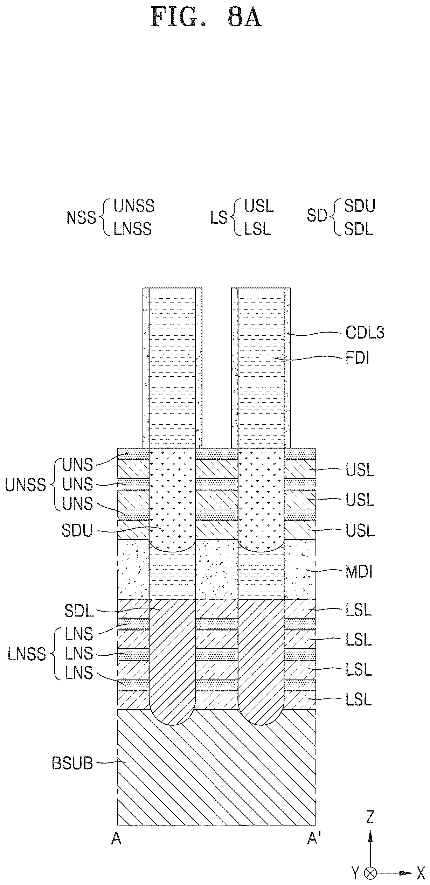

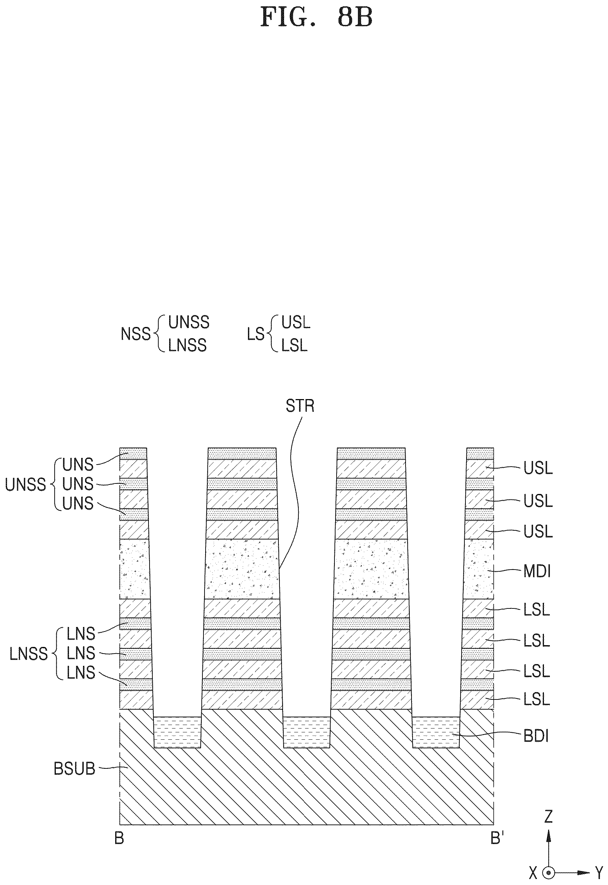

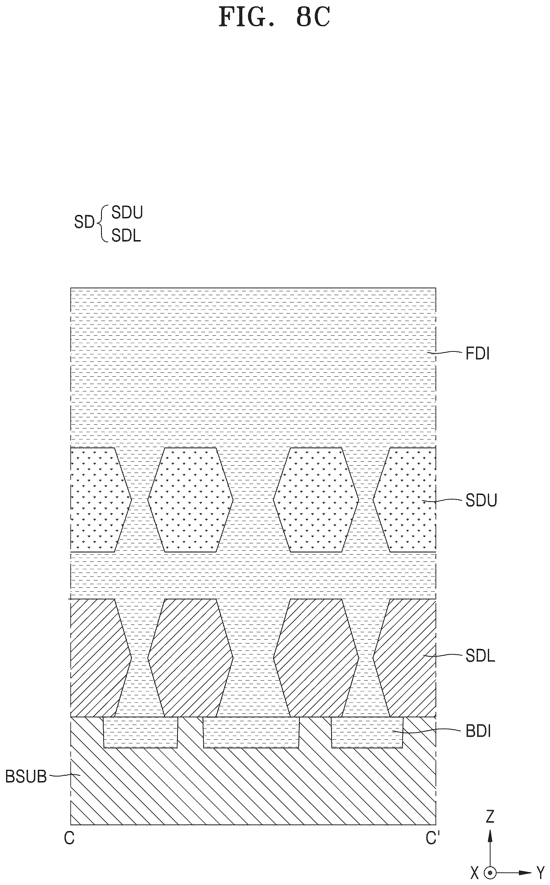

Referring to FIGS. 8A to 8C, the dummy gate layers DPC may be at least partially exposed by removing the second insulating material layers CDL2. In the process of removing the second insulating material layers CDL2, an upper portion of each of the third insulating material layer CDL3 and the interlayer insulating layer FDI may also be removed. After the dummy gate layers DPC are removed, the first insulating material layer CDL1 may be removed.

In some embodiments, the dummy gate layers DPC may be removed by a wet etching process. For example, to perform the wet etching process, an etchant including HNO₃, diluted fluoric acid (DHF), NH₄OH, tetramethyl ammonium hydroxide (TMAH), KOH, or a combination thereof may be used.

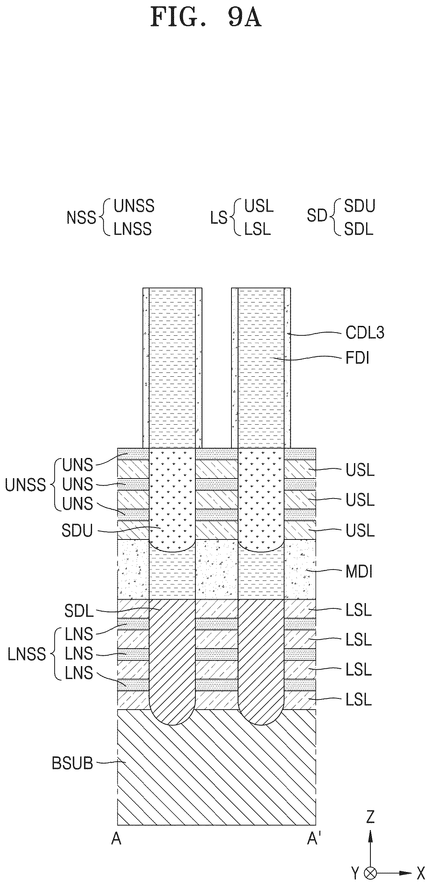

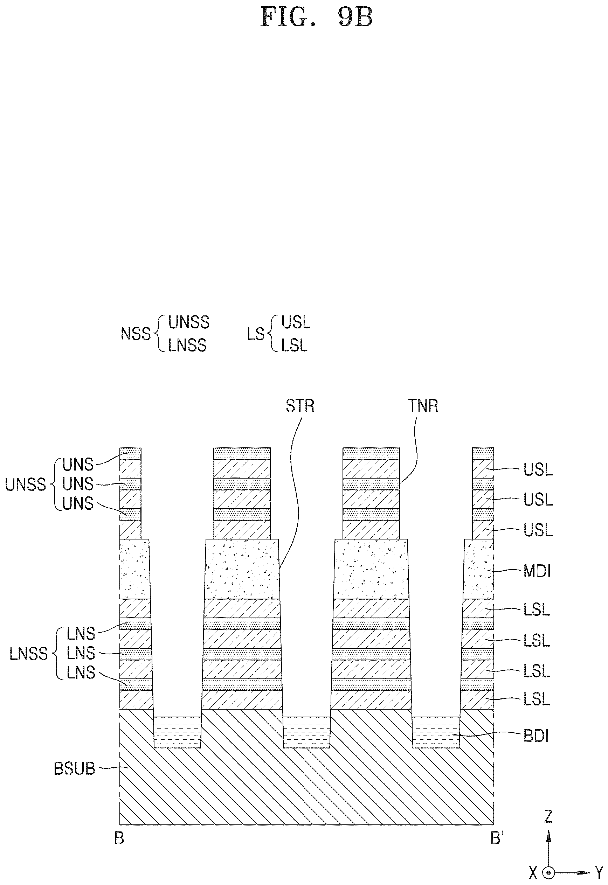

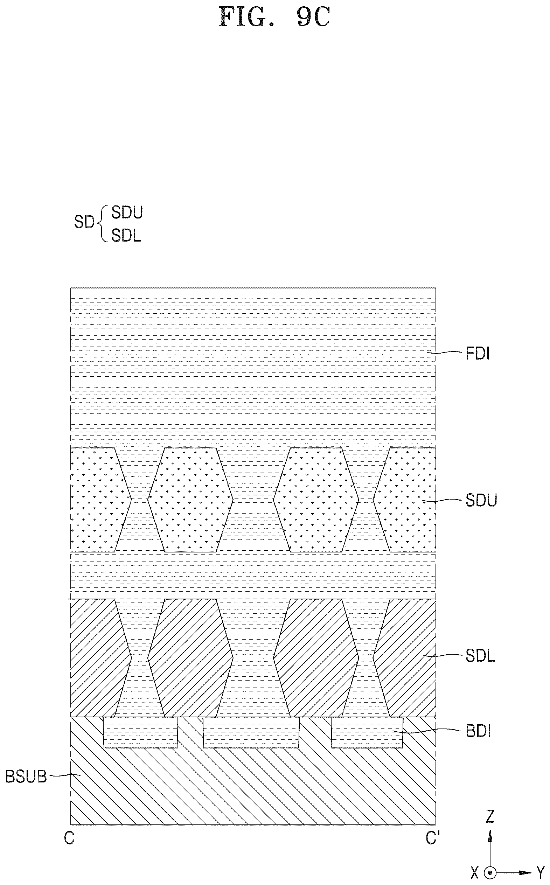

Referring to FIGS. 9A to 9C, a portion of each of the upper sacrificial layers USL and the upper nanosheets UNS of the upper nanosheet stack structure UNSS may be removed. As a result, in the second horizontal direction (the Y direction), the width of each of the upper nanosheets UNS and the upper sacrificial layers USL may be less than the width of each of the lower nanosheets LNS and the lower sacrificial layers LSL.

For example, a mold layer may be formed to cover or at least partially overlap the side surfaces of the lower nanosheets LNS and the lower sacrificial layers LSL and at least partially fill a lower portion of the isolation recess STR. Thereafter, opposite side portions in the second horizontal direction (the Y direction) of each of the upper nanosheets UNS and the upper sacrificial layers USL may be removed by an etching process. In some embodiments, during the etching process in which the portion of each of the upper nanosheets UNS and the upper sacrificial layers USL is removed, the intermediate insulating layer MDI may remain without being removed. For example, the horizontal width of the intermediate insulating layer MDI may be substantially the same as or similar to the width of each of the lower nanosheets LNS and the lower sacrificial layers LSL.

A recess space TNR may be defined between two upper nanosheet stack structures UNSS adjacent to each other in the second horizontal direction (the Y direction). In the second horizontal direction (the Y direction), the horizontal width of the recess space TNR may be greater than the horizontal width of the isolation recess STR defined between two lower nanosheet stack structures LNSS adjacent to each other in the second horizontal direction (the Y direction).

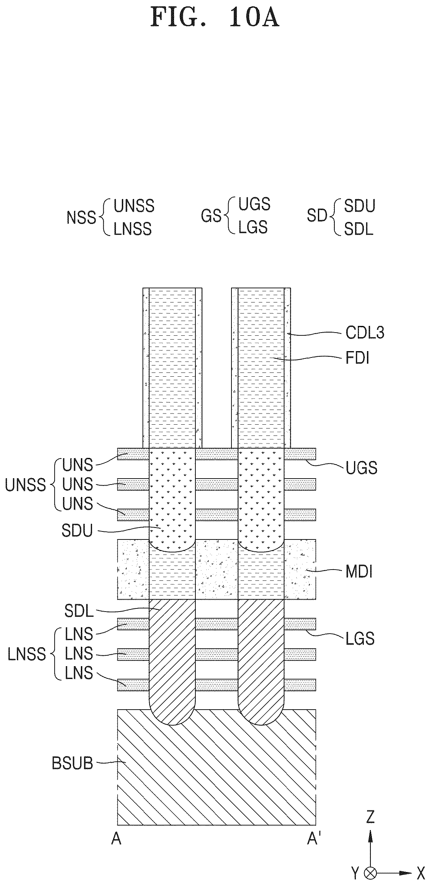

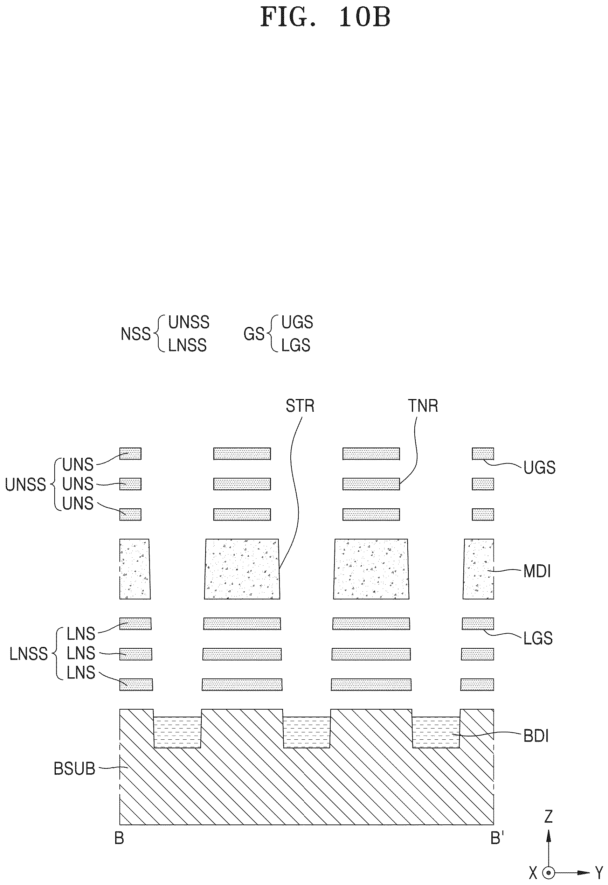

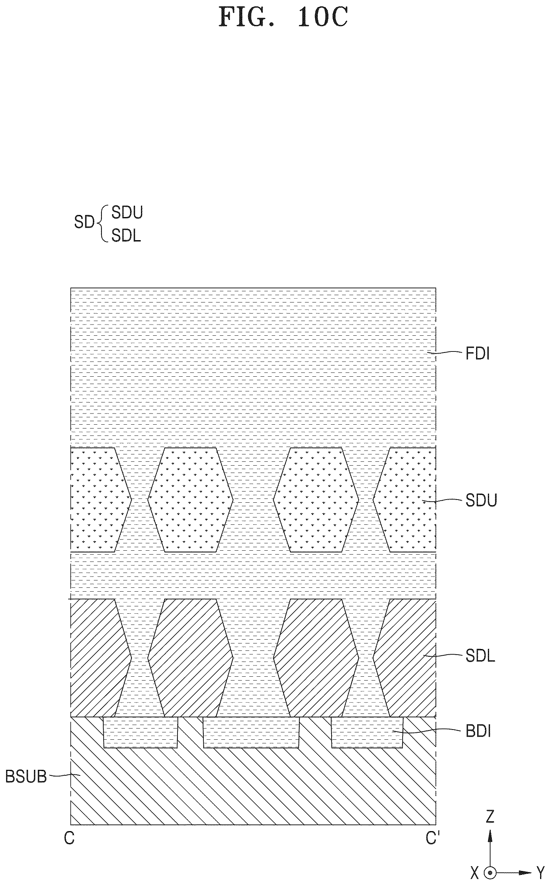

Referring to FIGS. 10A to 10C, a plurality of gate spaces GS may be formed by removing the sacrificial layers LS including the lower sacrificial layers LSL and the upper sacrificial layers USL. The gate spaces GS may include a plurality of lower gate spaces LGS, from which the lower sacrificial layers LSL have been removed, and a plurality of upper gate spaces UGS, from which the upper sacrificial layers USL have been removed.

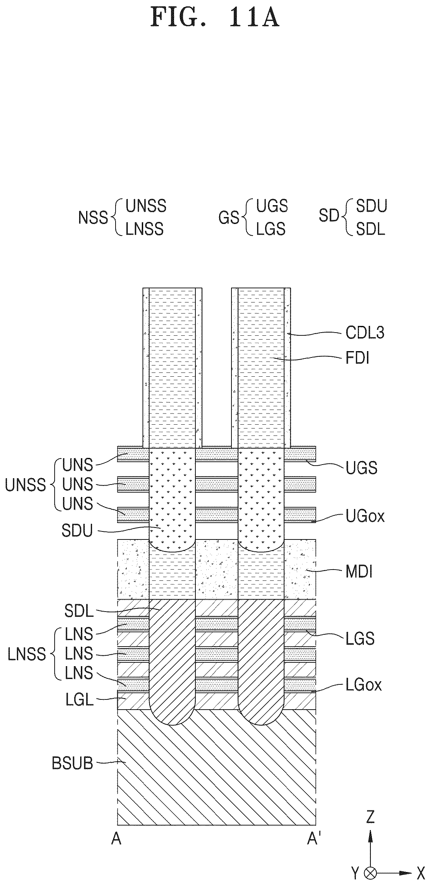

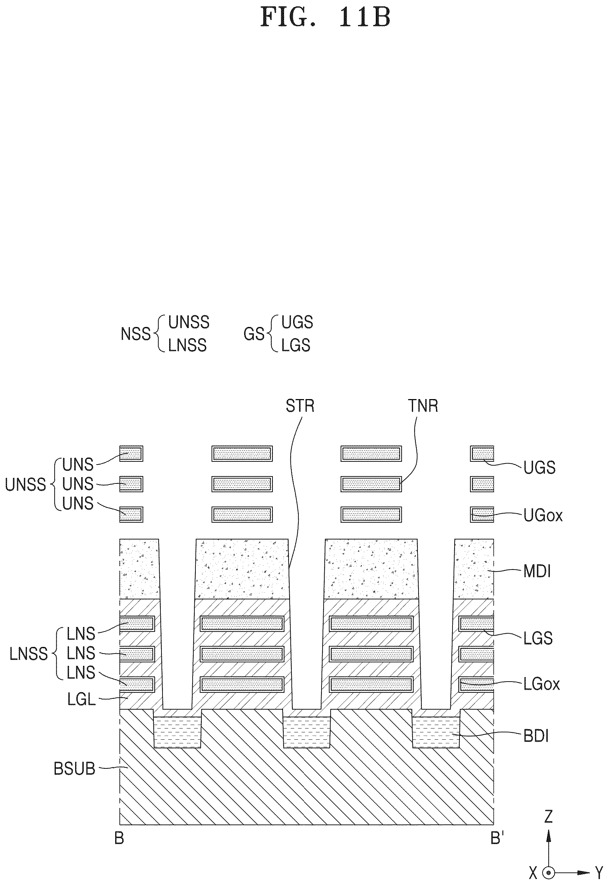

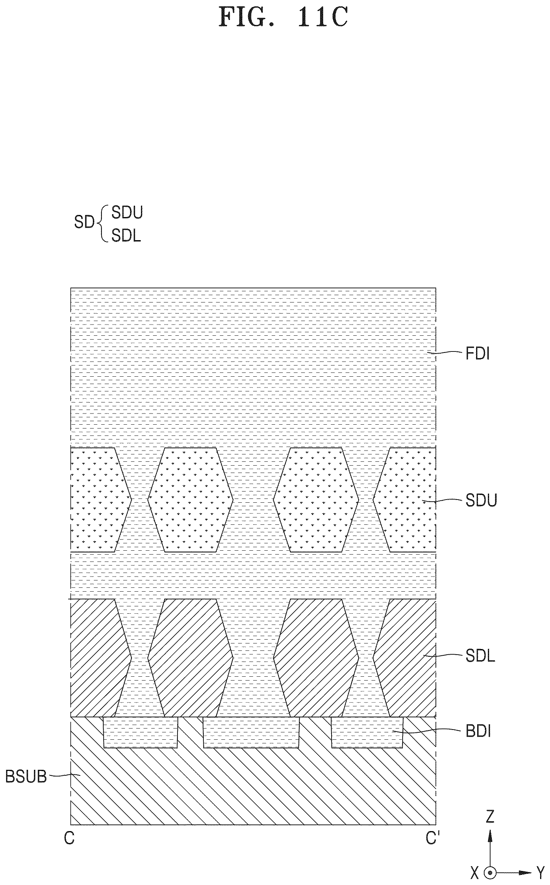

Referring to FIGS. 11A to 11C, a lower gate insulating layer LGox may be formed to surround or extend around the lower nanosheets LNS, and a lower gate electrode LGL may be formed to cover or extend around the lower gate insulating layer LGox and at least partially fill the lower gate spaces LGS. The lower gate insulating layer LGox and the lower gate electrode LGL may be formed by a replacement metal gate (RMG) process. The lower gate insulating layer LGox and the lower gate electrode LGL may be formed to surround or extend around the lower nanosheets LNS and at least partially fill a lower portion of the isolation recess STR. In some embodiments, the lower gate insulating layer LGox and the lower gate electrode LGL may be formed to fill only a portion of the space of the isolation recess STR between two lower nanosheet stack structures LNSS adjacent to each other in the second horizontal direction (the Y direction). For example, the lower gate electrode LGL may be formed to cover or at least partially overlap the lower gate insulating layer LGox and at least partially fill the lower gate spaces LGS so as to surround or extend around the lower nanosheets LNS and may be formed to cover or overlap the bottom surface of the isolation recess STR and a portion of the inner sidewall of the isolation recess STR. The lower gate electrode LGL may cover or overlap at least a portion of the top surface of the lower insulating layer BDI. In some embodiments, the lower gate electrode LGL may fully or entirely cover or overlap the top surface of the lower insulating layer BDI, but embodiments are not limited thereto. For example, the lower gate electrode LGL may not cover or be free from overlap with at least a portion of the top surface of the lower insulating layer BDI. The top end of the lower gate electrode LGL may be between the bottom and top surfaces of the intermediate insulating layer MDI. For example, the top end of the lower gate electrode LGL may be at a vertical level that is higher than or equal to the bottom surface of the intermediate insulating layer MDI and lower than or equal to the top surface of the intermediate insulating layer MDI in the Z direction.

The lower gate insulating layer LGox may include silicon oxide, a high-k dielectric film, or a combination thereof. In some embodiments, the lower gate insulating layer LGox may have a stack structure of an interfacial layer and a high-k dielectric film. The interfacial layer may include a low-k dielectric material having a permittivity of about 9 or less. For example, the interfacial layer may include oxide, nitride, or oxynitride. The high-k dielectric film may include metal oxide or metal oxynitride. The high-k dielectric film may include a material having a higher dielectric constant than a silicon oxide film. For example, the high-k dielectric film may have a dielectric constant of about 10 to about 25. The high-k dielectric film may have a thickness of about 1 nm to about 4 nm but is not limited thereto. In some embodiments, the interfacial layer may be omitted. For example, the lower gate insulating layer LGox may include HfO₂, Al₂O₃, HfAlO₃, Ta₂O₃, or TiO₂.

The lower gate electrode LGL may include a work function metal layer and a gap-fill metal layer at least partially filling a space above the work function metal layer. The work function metal layer may include at least one metal selected from the group consisting of Ti, W, Ru, Nb, Mo, Hf, Ni, Co, Pt, Yb, Tb, Dy, Er, and Pd. In some embodiments, the lower gate electrode LGL may have a structure in which a metal nitride layer, a metal layer, a conductive capping layer, and a gap-fill metal film are sequentially stacked. The metal nitride layer and the metal layer may include at least one metal selected from the group consisting of Ti, Ta, W, Ru, Nb, Mo, and Hf. The gap-fill metal film may include a W film or an Al film. In some embodiments, the lower gate electrode LGL may have a stack structure of TiAlC/TiN/W, a stack structure of TiN/TaN/TiAlC/TiN/W, or a stack structure of TiN/TaN/TiN/TiAlC/TiN/W but is not limited thereto.

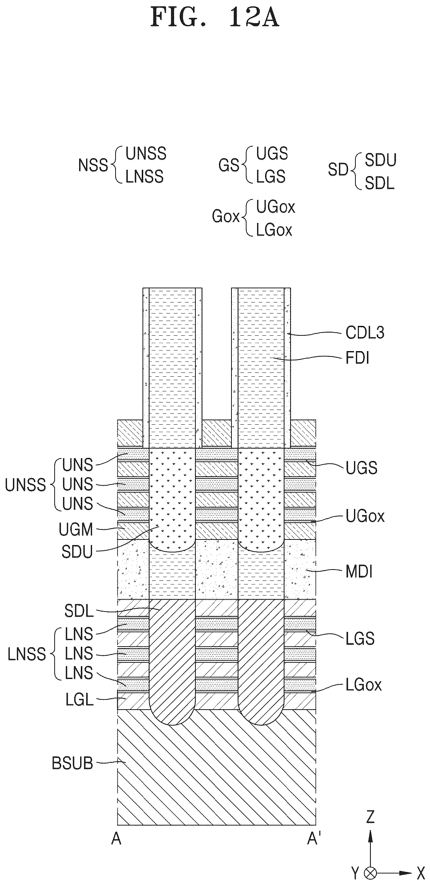

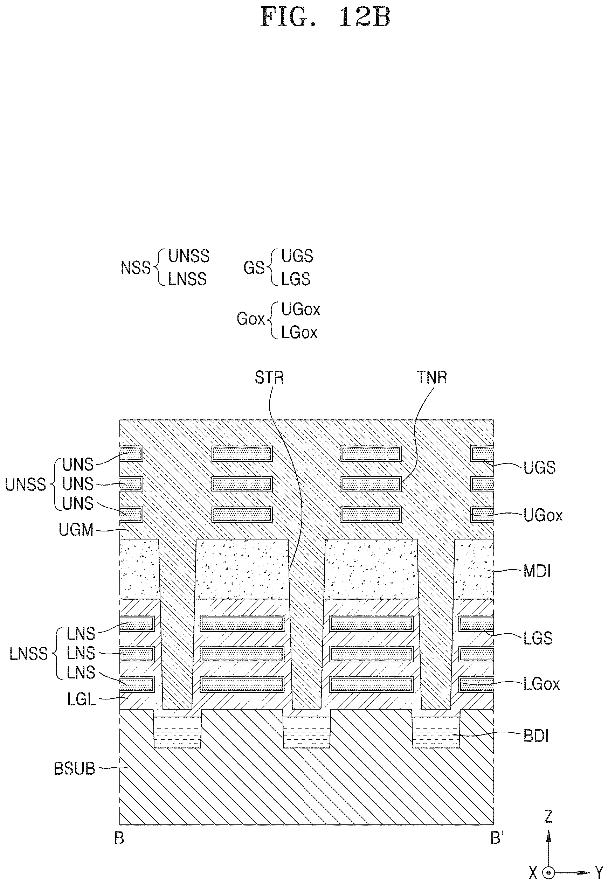

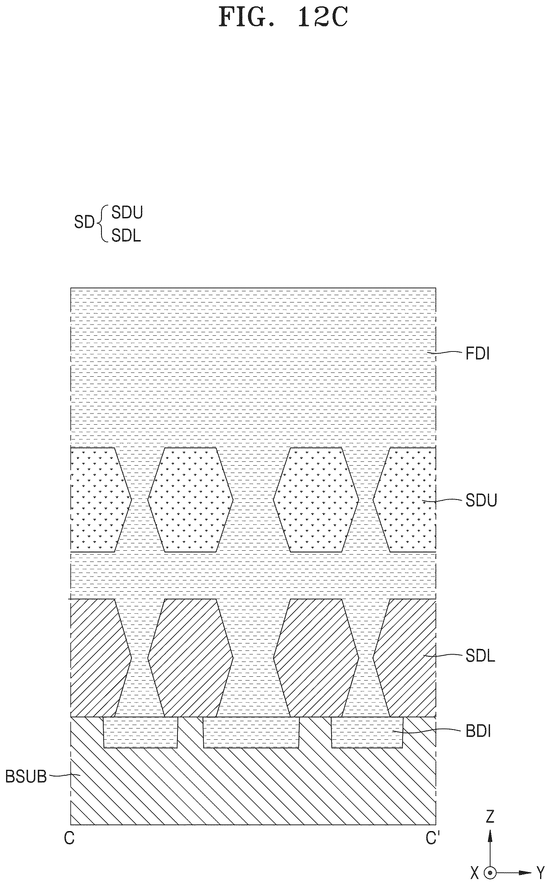

Referring to FIGS. 12A to 12C, an upper gate insulating layer UGox may be formed to surround or extend around the upper nanosheets UNS, and an upper main gate layer UGM may be formed to cover or at least partially overlap the upper gate insulating layer UGox and at least partially fill the upper gate spaces UGS. The upper gate insulating layer UGox and the upper main gate layer UGM may be formed by an RMG process. The upper gate insulating layer UGox and the upper main gate layer UGM may be formed to surround or extend around the upper nanosheets UNS and fully or entirely fill the recess space TNR and the isolation recess STR. For example, the recess space TNR between two upper nanosheet stack structures UNSS adjacent to each other in the second horizontal direction (the Y direction) may be fully or entirely filled by the upper gate insulating layer UGox and the upper main gate layer UGM. For example, a space, which has not been filled by the lower gate insulating layer LGox and the lower gate electrode LGL in the space of the isolation recess STR between two lower nanosheet stack structures LNSS adjacent to each other in the second horizontal direction (the Y direction), may be fully or entirely filled by the upper main gate layer UGM. The upper main gate layer UGM may extend to a lower portion of the isolation recess STR. For example, the upper main gate layer UGM may extend between two lower nanosheet stack structures LNSS adjacent to each other in the second horizontal direction (the Y direction). The upper main gate layer UGM in the lower portion of the isolation recess STR may be separated from the lower nanosheets LNS by the lower gate electrode LGL. The upper main gate layer UGM may be separated from the lower insulating layer BDI by the lower gate electrode LGL. In some embodiments, when the lower gate electrode LGL does not cover or overlap at least a portion of the top surface of the lower insulating layer BDI, the upper main gate layer UGM may be formed to cover or overlap the portion of the top surface of the lower insulating layer BDI that is not covered or overlapped by the lower gate electrode LGL.

The upper main gate layer UGM may be formed to cover or at least partially overlap the upper gate insulating layer UGox such that the top surface of the upper main gate layer UGM is at a vertical level higher than the top surface of the topmost upper nanosheet UNS among the upper nanosheets UNS of an upper nanosheet stack structure UNSS.

The upper gate insulating layer UGox may include silicon oxide, a high-k dielectric film, or a combination thereof. In some embodiments, the upper gate insulating layer UGox may have a stack structure of an interfacial layer and a high-k dielectric film. The interfacial layer may include a low-k dielectric material having a permittivity of about 9 or less. The high-k dielectric film may include metal oxide or metal oxynitride. The high-k dielectric film may include a material having a higher dielectric constant than a silicon oxide film. For example, the high-k dielectric film may have a dielectric constant of about 10 to about 25. In some embodiments, the interfacial layer may be omitted. For example, the upper gate insulating layer UGox may include HfO₂, Al₂O₃, HfAlO₃, Ta₂O₃, or TiO₂.

The upper main gate layer UGM may include a work function metal layer and a gap-fill metal layer at least partially filling a space above the work function metal layer. The work function metal layer may include at least one metal selected from the group consisting of Ti, W, Ru, Nb, Mo, Hf, Ni, Co, Pt, Yb, Tb, Dy, Er, and Pd. In some embodiments, at least a portion of the work function metal layer of the upper main gate layer UGM may include a material that is different from a material of the work function metal layer of the lower gate electrode LGL. In some embodiments, the upper main gate layer UGM may have a structure in which a metal nitride layer, a metal layer, a conductive capping layer, and a gap-fill metal film are sequentially stacked. In some embodiments, the upper main gate layer UGM may have a stack structure of TiAlC/TiN/W, a stack structure of TiN/TaN/TiAlC/TiN/W, or a stack structure of TiN/TaN/TiN/TiAlC/TiN/W but is not limited thereto.

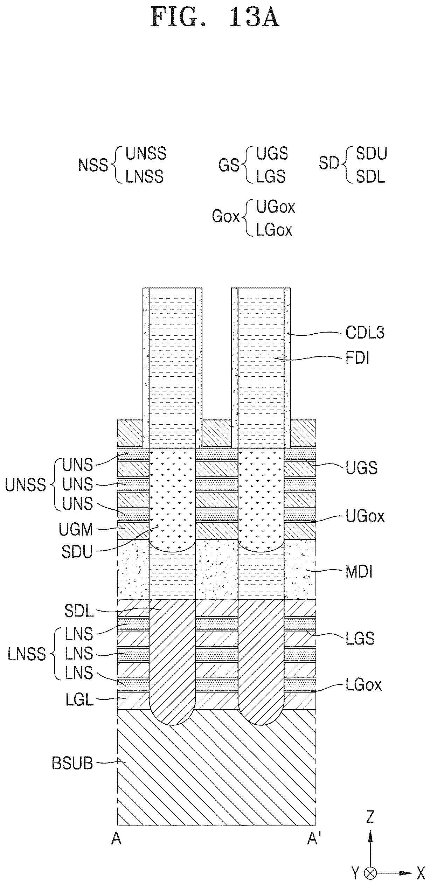

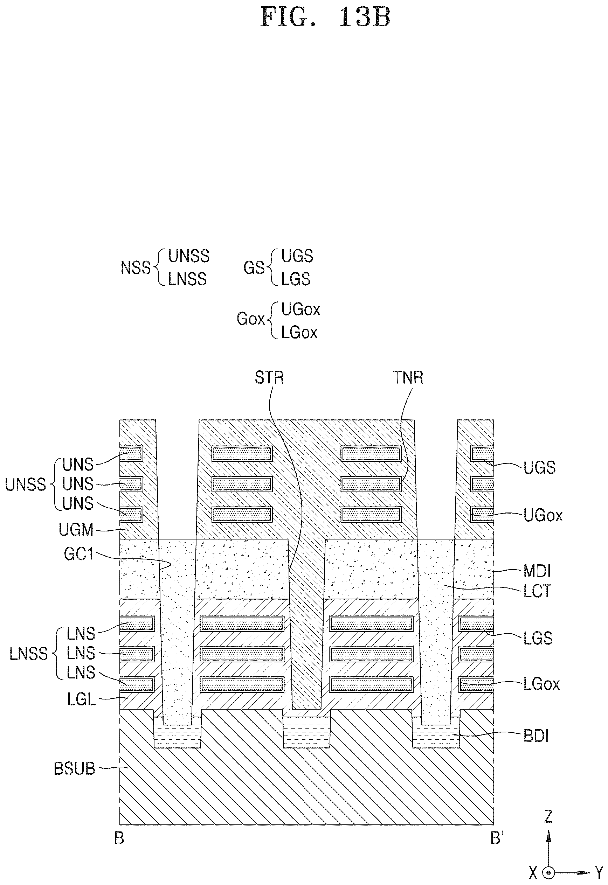

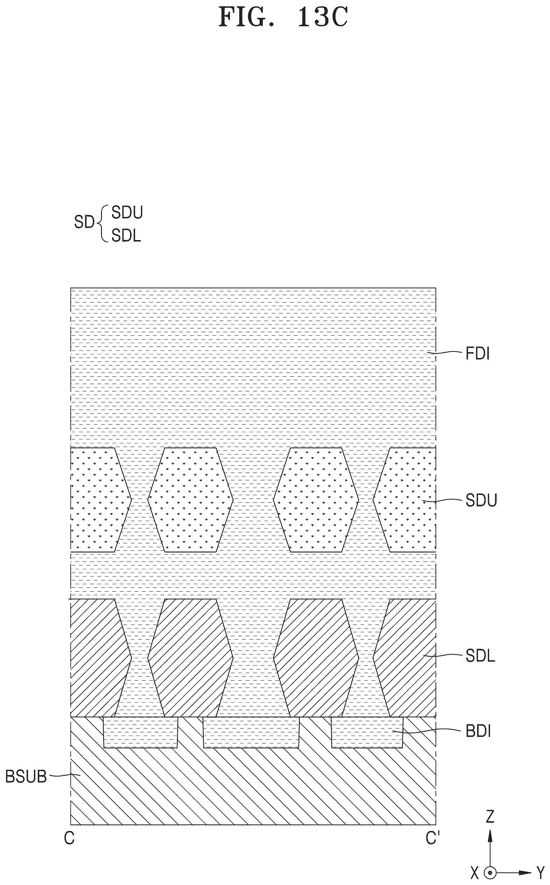

Referring to FIGS. 13A to 13C, a first gate cut space GC1 may be formed between two nanosheet stack structures NSS adjacent to each other in the second horizontal direction (the Y direction) to extend from the top surface of the upper main gate layer UGM to the lower insulating layer BDI. The first gate cut space GC1 may be formed to at least partially expose the side surface of the intermediate insulating layer MDI. Portions of the upper main gate layer UGM, which surround or extend around two upper nanosheet stack structures UNSS respectively at opposite sides of the first gate cut space GC1 in the second horizontal direction (the Y direction), may be separated by the first gate cut space GC1. Portions of the lower gate electrode LGL, which surround or extend around two lower nanosheet stack structures LNSS respectively at opposite sides of the first gate cut space GC1 in the second horizontal direction (the Y direction), may be separated by the first gate cut space GC1.

The first gate cut space GC1 may be formed between two nanosheet stack structures NSS adjacent to each other in the second horizontal direction (the Y direction) among the plurality of nanosheet stack structures NSS but not between two other nanosheet stack structures NSS adjacent to each other in the second horizontal direction (the Y direction). For example, when the first gate cut space GC1 is not formed between two nanosheet stack structures NSS adjacent to each other in the second horizontal direction (the Y direction), a portion of the upper main gate layer UGM, which surrounds or extends around two upper nanosheet stack structures UNSS, may not be separated from a portion of the lower gate electrode LGL, which surrounds or extends around two lower nanosheet stack structures LNSS, but may form one integrated body with the portion of the lower gate electrode LGL.

A lower gate cut structure LCT may be formed in a lower portion of the first gate cut space GC1. The lower gate cut structure LCT may at least partially fill a lower portion of the first gate cut space GC1 such that the lower gate cut structure LCT is between two lower nanosheet stack structures LNSS adjacent to each other in the second horizontal direction (the Y direction) but not between two upper nanosheet stack structures UNSS adjacent to each other in the second horizontal direction (the Y direction). The top end of the lower gate cut structure LCT may be between the top end of the lower gate electrode LGL and the bottom end of the upper main gate layer UGM. For example, the top end of the lower gate cut structure LCT may be at a vertical level that is higher than or equal to the top end of the lower gate electrode LGL, i.e., the bottom surface of the intermediate insulating layer MDI. For example, the top end of the lower gate cut structure LCT may be at a vertical level that is lower than or equal to the bottom end of the upper main gate layer UGM, i.e., the top surface of the intermediate insulating layer MDI. The lower gate cut structure LCT may include nitride. For example, the lower gate cut structure LCT may include silicon nitride.

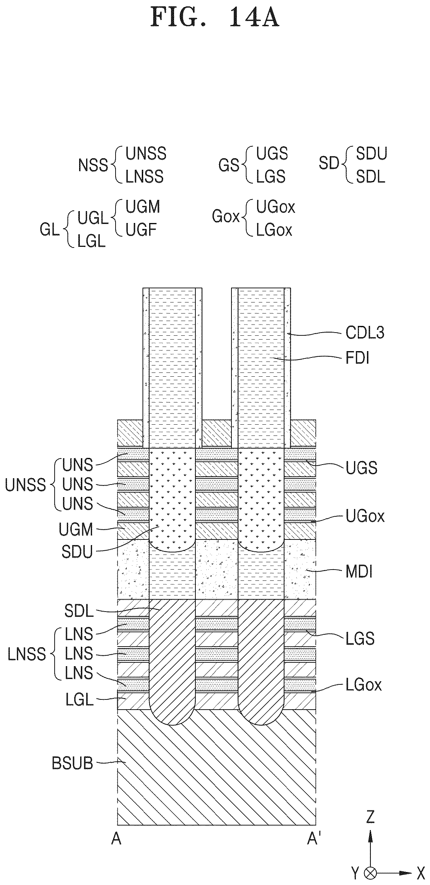

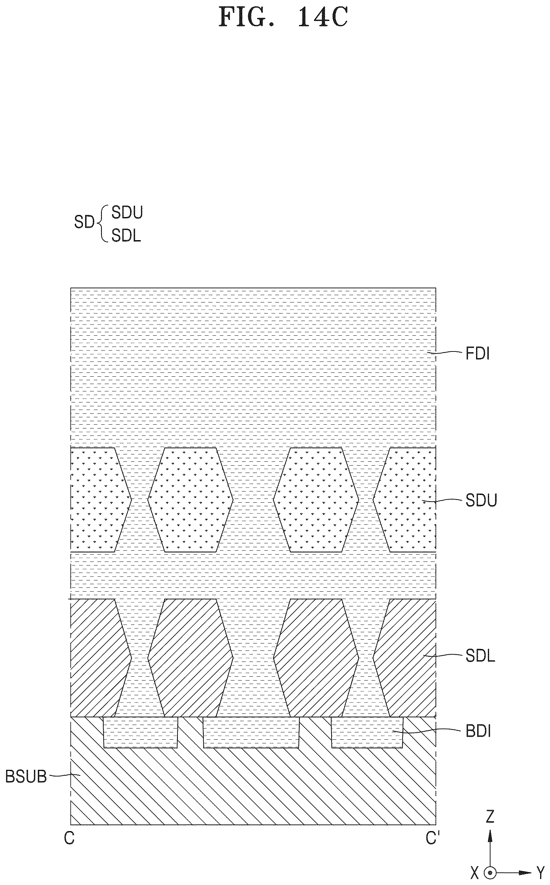

Referring to FIGS. 14A to 14C, an upper filling gate layer UGF may be formed to at least partially fill an upper portion of the first gate cut space GC1. The first gate cut space GC1 may be fully or entirely filled by the lower gate cut structure LCT and the upper filling gate layer UGF. The upper filling gate layer UGF may connect upper main gate layers UGM, which are separated by the first gate cut space GC1. At least a portion of the upper filling gate layer UGF may include the same material as at least a portion of the upper main gate layer UGM. In some embodiments, at least a portion of the upper filling gate layer UGF may include the same material as the gap-fill metal layer of the upper main gate layer UGM. For example, the upper filling gate layer UGF may include W or a stack structure of TiN/W.

The upper main gate layer UGM and the upper filling gate layer UGF may form an upper gate electrode UGL. The upper gate electrode UGL and the lower gate electrode LGL may form a gate electrode GL. The gate electrode GL may correspond to the gate of a pull-up transistor PU, the gate of a pull-down transistor PD, or the gate of a pass-gate transistor PG in FIG. 1.

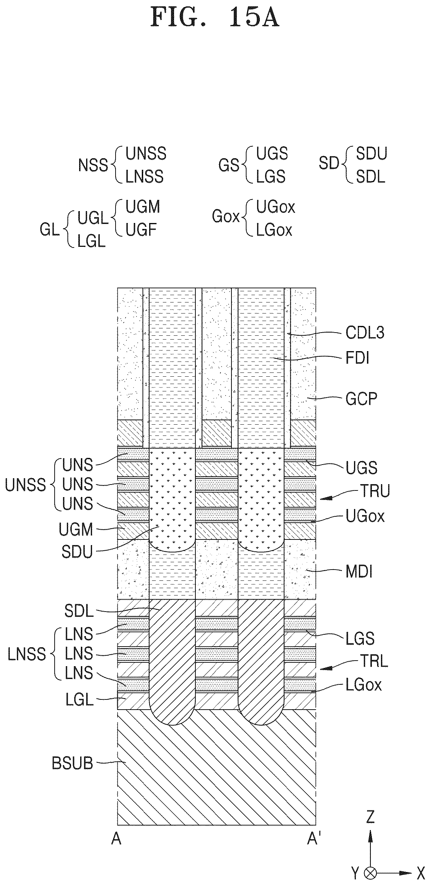

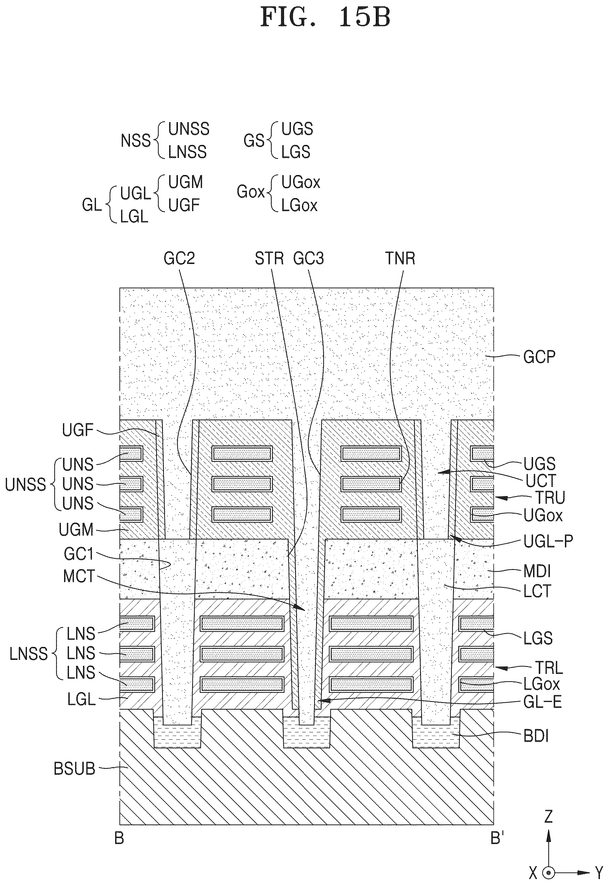

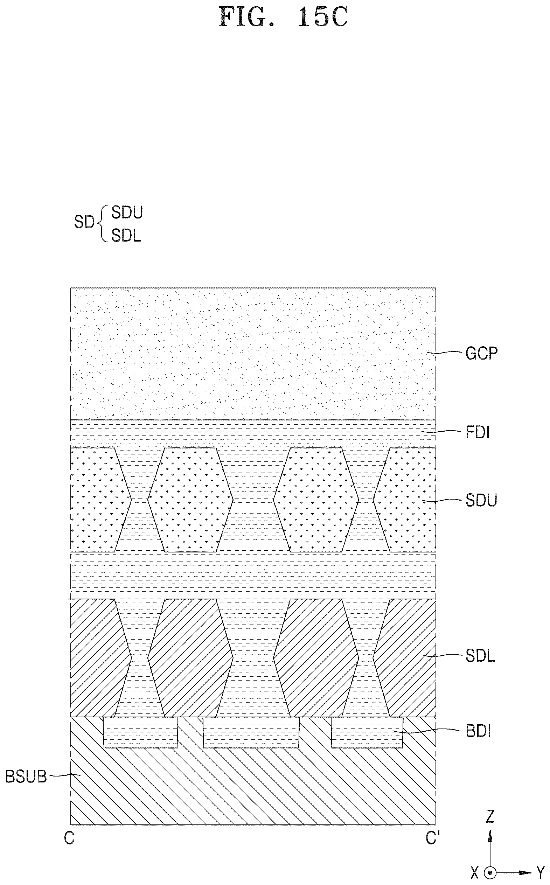

Referring to FIGS. 15A to 15C, a second gate cut space GC2 may be formed through the upper filling gate layer UGF to at least partially expose the lower gate cut structure LCT at the bottom of the second gate cut space GC2. A third gate cut space GC3 may be formed through the upper main gate layer UGM to at least partially expose the lower insulating layer BDI at the bottom of the third gate cut space GC3. The second gate cut space GC2 may be formed in the first gate cut space GC1. A lower portion of the first gate cut space GC1 may be at least partially filled by the lower gate cut structure LCT. A portion of an upper portion of the first gate cut space GC1 may be at least partially filled by the upper filling gate layer UGF, and the other portion of the upper portion of the first gate cut space GC1 may correspond to the second gate cut space GC2 defined by the upper filling gate layer UGF or by the upper filling gate layer UGF and the upper main gate layer UGM.. The third gate cut space GC3 may be formed between two nanosheet stack structures NSS adjacent to each other in the second horizontal direction (the Y direction), wherein the first gate cut space GC1 is not formed between the two nanosheet stack structures NSS. The third gate cut space GC3 may be formed between two nanosheet stack structures NSS adjacent to each other in the second horizontal direction (the Y direction) to extend from the top surface of the upper main gate layer UGM filling between the two nanosheet stack structures NSS to the lower insulating layer BDI.

Portions of the upper gate electrode UGL, which surround or extend around two upper nanosheet stack structures UNSS respectively at opposite sides of the second gate cut space GC2 in the second horizontal direction (the Y direction), may be separated by the second gate cut space GC2. Portions of the upper gate electrode UGL, which surround or extend around two upper nanosheet stack structures UNSS respectively at opposite sides of the third gate cut space GC3 in the second horizontal direction (the Y direction), may be separated by the third gate cut space GC3. Portions of the upper gate electrode UGL, which are respectively in contact with portions of the lower gate electrode LGL surrounding or extending around two lower nanosheet stack structures LNSS respectively at opposite sides of the third gate cut space GC3 in the second horizontal direction (the Y direction), may be separated by the third gate cut space GC3.

Thereafter, an upper gate cut structure UCT at least partially filling the second gate cut space GC2, a coupling gate cut structure MCT at least partially filling the third gate cut space GC3, and a gate capping layer GCP covering or at least partially overlapping the gate electrode GL may be formed. The upper gate cut structure UCT and the coupling gate cut structure MCT may each include nitride. For example, the upper gate cut structure UCT and the coupling gate cut structure MCT may each include silicon nitride. In some embodiments, the upper gate cut structure UCT and the coupling gate cut structure MCT may be simultaneously formed of the same material. The gate capping layer GCP may include nitride. For example, the gate capping layer GCP may include silicon nitride. In some embodiments, the upper gate cut structure UCT, the coupling gate cut structure MCT, and the gate capping layer GCP may be simultaneously and integrally formed of the same material.

The lower gate cut structure LCT may be between two lower nanosheet stack structures LNSS adjacent to each other in the second horizontal direction (the Y direction) such that portions of the lower gate electrode LGL, which surround or extend around the two lower nanosheet stack structures LNSS respectively at opposites sides of the lower gate cut structure LCT in the second horizontal direction (the Y direction), may be separated by the lower gate cut structure LCT. In other words, respective gates of two transistors respectively formed in the two lower nanosheet stack structures LNSS respectively at opposite sides of the lower gate cut structure LCT in the second horizontal direction (the Y direction) may not be connected to each other.

The upper gate cut structure UCT may be between two upper nanosheet stack structures UNSS adjacent to each other in the second horizontal direction (the Y direction) such that portions of the upper gate electrode UGL, which surround or extend around the two upper nanosheet stack structures UNSS respectively at opposites sides of the upper gate cut structure UCT in the second horizontal direction (the Y direction), may be separated by the upper gate cut structure UCT. In other words, respective gates of two transistors respectively formed in the two upper nanosheet stack structures UNSS respectively at opposite sides of the upper gate cut structure UCT in the second horizontal direction (the Y direction) may not be connected to each other.

The upper gate cut structure UCT may be formed on the lower gate cut structure LCT. The upper gate cut structure UCT may be in contact with the lower gate cut structure LCT. Both the lower gate cut structure LCT and the upper gate cut structure UCT on the lower gate cut structure LCT may be between two nanosheet stack structures NSS, which are adjacent to each other in the second horizontal direction (the Y direction) and each include an upper nanosheet stack structure UNSS and a lower nanosheet stack structure LNSS, such that portions of the upper gate electrode UGL, which surround or extend around upper nanosheet stack structures UNSS respectively included in the two nanosheet stack structures NSS respectively at opposite sides of a structure of the lower gate cut structure LCT and the upper gate cut structure UCT on the lower gate cut structure LCT in the second horizontal direction (the Y direction), may be separated by the upper gate cut structure UCT and portions of the lower gate electrode LGL, which surround or extend around lower nanosheet stack structures LNSS respectively included in the two nanosheet stack structures NSS respectively at opposite sides of the structure of the lower gate cut structure LCT and the upper gate cut structure UCT on the lower gate cut structure LCT in the second horizontal direction (the Y direction), may be separated by the lower gate cut structure LCT. In other words, respective gates of two transistors respectively formed in an upper nanosheet stack structure UNSS and a lower nanosheet stack structure LNSS, which are included in a nanosheet stack structure NSS on at least one side of the structure of the lower gate cut structure LCT and the upper gate cut structure UCT on the lower gate cut structure LCT in the second horizontal direction (the Y direction), may not be connected to each other.

The coupling gate cut structure MCT may be between two nanosheet stack structures NSS, which are adjacent to each other in the second horizontal direction (the Y direction) and each include an upper nanosheet stack structure UNSS and a lower nanosheet stack structure LNSS, such that portions of the upper gate electrode UGL, which surround or extend around upper nanosheet stack structures UNSS respectively included in the two nanosheet stack structures NSS respectively at opposite sides of the coupling gate cut structure MCT in the second horizontal direction (the Y direction), may be separated by the coupling gate cut structure MCT and portions of the lower gate electrode LGL, which surround or extend around lower nanosheet stack structures LNSS respectively included in the two nanosheet stack structures NSS respectively at opposite sides of the coupling gate cut structure MCT in the second horizontal direction (the Y direction), may be separated by the coupling gate cut structure MCT. In other words, respective gates of two transistors, which are respectively formed in the upper nanosheet stack structures UNSS respectively included in the two nanosheet stack structures NSS respectively at opposite sides of the coupling gate cut structure MCT in the second horizontal direction (the Y direction), may not be connected to each other, and respective gates of two transistors, which are respectively formed in the lower nanosheet stack structures LNSS respectively included in the two nanosheet stack structures NSS respectively at opposite sides of the coupling gate cut structure MCT in the second horizontal direction (the Y direction), may not be connected to each other.

A portion of the lower gate electrode LGL, which surrounds or extends around a lower nanosheet stack structure LNSS included in each of two nanosheet stack structures NSS respectively at opposite sides of the coupling gate cut structure MCT in the second horizontal direction (the Y direction), may be in contact with and electrically connected to a portion of the upper gate electrode UGL, which surrounds or extends around an upper nanosheet stack structure UNSS included in each of the two nanosheet stack structures NSS. In other words, respective gates of two transistors respectively formed in an upper nanosheet stack structure UNSS and a lower nanosheet stack structure LNSS, which are included in each of the two nanosheet stack structures NSS respectively at opposite sides of the coupling gate cut structure MCT in the second horizontal direction (the Y direction), may be connected to each other.

FIGS. 16A to 16C are cross-sectional views illustrating a stacked integrated circuit device according to embodiments. In detail, FIG. 16A is a cross-sectional view taken along a position corresponding to line A-A' in FIG. 2, FIG. 16B is a cross-sectional view taken along a position corresponding to line B-B' in FIG. 2, and FIG. 16C is a cross-sectional view taken along a position corresponding to line C-C' in FIG. 2.

Referring to FIGS. 16A to 16C, a stacked integrated circuit device 1 may be formed by forming a first contact plug CTA connected to the upper source/drain region SDU and a second contact plug CTB connected to the lower source/drain region SDL. In some embodiments, the stacked integrated circuit device 1 may further include a third contact plug CTC connecting the upper source/drain region SDU to the lower source/drain region SDL. The first contact plug CTA, the second contact plug CTB, and the third contact plug CTC may each include metal. In some embodiments, the first contact plug CTA, the second contact plug CTB, and the third contact plug CTC may each include a metal layer and a conductive metal nitride layer surrounding the metal layer. For example, the metal layer may include W or Al, and the conductive metal nitride layer may include TiN or TaN.

The first contact plug CTA may be formed to be connected to an upper portion of the upper source/drain region SDU through the interlayer insulating layer FDI and/or the gate capping layer GCP. The second contact plug CTB may be formed to be connected to a lower portion of the lower source/drain region SDL through the lower insulating layer BDI and/or the base substrate layer BSUB. The third contact plug CTC may be formed to be connected to an upper portion of the lower source/drain region SDL through the gate capping layer GCP, the upper source/drain region SDU, and the interlayer insulating layer FDI, but is not limited thereto. For example, the third contact plug CTC may be formed to be connected to a lower portion of the upper source/drain region SDU through the lower insulating layer BDI, the lower source/drain region SDL, the interlayer insulating layer FDI, and/or the base substrate layer BSUB.

Before the first contact plug CTA and/or the third contact plug CTC is formed, an upper portion of each of the gate capping layer GCP, the third insulating material layer CDL3, and the interlayer insulating layer FDI may be removed. Before the second contact plug CTB is formed, a lower portion of the base substrate layer BSUB may be removed. In some embodiments, before the second contact plug CTB is formed, a lower portion of the base substrate layer BSUB may be removed to at least partially expose the lower insulating layer BDI. In the process of forming the second contact plug CTB, at least a portion of the remaining portion of the base substrate layer BSUB may be removed. For example, the second contact plug CTB may be formed to be connected to a lower portion of the lower source/drain region SDL through the lower insulating layer BDI.

The stacked integrated circuit device 1 may include a lower insulating layer BDI, a plurality of nanosheet stack structures NSS each including a lower nanosheet stack structure LNSS on the lower insulating layer BDI and an upper nanosheet stack structure UNSS on the lower nanosheet stack structure LNSS, an intermediate insulating layer MDI between the lower nanosheet stack structure LNSS and the upper nanosheet stack structure UNSS, a gate electrode GL including a lower gate electrode LGL surrounding or extending around the lower nanosheet stack structure LNSS and an upper gate electrode UGL surrounding or extending around the upper nanosheet stack structure UNSS, a first contact plug CTA connected to an upper source/drain region SDU, a second contact plug CTB connected to a lower source/drain region SDL, a lower gate cut structure LCT between two lower nanosheet stack structures LNSS adjacent to each other in the second horizontal direction (the Y direction), an upper gate cut structure UCT on the lower gate cut structure LCT and between two upper nanosheet stack structures UNSS adjacent to each other in the second horizontal direction (the Y direction), and a coupling gate cut structure MCT between two nanosheet stack structures NSS adjacent to each other in the second horizontal direction (the Y direction), wherein two coupling gate cut structures MCT may be separated by at least one nanosheet stack structure NSS and a structure of the lower gate cut structure LCT and the upper gate cut structure UCT on the lower gate cut structure LCT. The upper gate electrode UGL may include a connection extension GL-E and a protrusion UGL-P. The lower gate cut structure LCT may at least partially fill a lower portion of the first gate cut space GC1, the upper gate cut structure UCT may at least partially fill the second gate cut space GC2, and the coupling gate cut structure MCT may at least partially fill the third gate cut space GC3. The protrusion UGL-P of the upper gate electrode UGL and the upper gate cut structure UCT may at least partially fill an upper portion of the first gate cut space GC1.

The lower nanosheet stack structure LNSS may include a plurality of lower nanosheets LNS. The lower nanosheets LNS may be spaced apart from each other in the vertical direction (the Z direction). The upper nanosheet stack structure UNSS may include a plurality of upper nanosheets UNS. The upper nanosheets UNS may be spaced apart from each other in the vertical direction (the Z direction). Each of the upper nanosheets UNS may have a first horizontal width W1 in the second horizontal direction (the Y direction). Each of the lower nanosheets LNS may have a second horizontal width W2 in the second horizontal direction (the Y direction), wherein the second horizontal width W2 may be greater than the first horizontal width W1.

The stacked integrated circuit device 1 may further include the first contact plug CTA connected to the upper source/drain region SDU, the second contact plug CTB connected to the lower source/drain region SDL, and the third contact plug CTC connecting the upper source/drain region SDU to the lower source/drain region SDL. In some embodiments, the stacked integrated circuit device 1 may further include the base substrate layer BSUB below the lower nanosheet stack structure LNSS and the lower insulating layer BDI.

The lower gate cut structure LCT and the upper gate cut structure UCT on the lower gate cut structure LCT may be between two nanosheet stack structures NSS adjacent to each other in the second horizontal direction (the Y direction) among the plurality of nanosheet stack structures NSS, and the coupling gate cut structure MCT may be between two other nanosheet stack structures NSS adjacent to each other in the second horizontal direction (the Y direction). In other words, when the lower gate cut structure LCT and the upper gate cut structure UCT on the lower gate cut structure LCT are between two nanosheet stack structures NSS adjacent to each other in the second horizontal direction (the Y direction), the coupling gate cut structure MCT may not be between the two nanosheet stack structures NSS. When the coupling gate cut structure MCT is between two nanosheet stack structures NSS adjacent to each other in the second horizontal direction (the Y direction), the lower gate cut structure LCT and the upper gate cut structure UCT may not be between the two nanosheet stack structures NSS.

The lower nanosheet stack structure LNSS included in each of the nanosheet stack structures NSS and the lower gate electrode LGL surrounding or extending around the lower nanosheet stack structure LNSS may form a lower transistor TRL. The upper nanosheet stack structure UNSS included in each of the nanosheet stack structures NSS and the upper gate electrode UGL surrounding or extending around the upper nanosheet stack structure UNSS may form an upper transistor TRU. The lower transistor TRL and the upper transistor TRU may be different types of MOS transistors. In some embodiments, the lower transistor TRL may be a PMOS transistor, and the upper transistor TRU may be an NMOS transistor. In some embodiments, the lower transistor TRL may be an NMOS transistor, and the upper transistor TRU may be a PMOS transistor.

The lower gate cut structure LCT may be between two lower nanosheet stack structures LNSS adjacent to each other in the second horizontal direction (the Y direction) such that portions of the lower gate electrode LGL, which surround or extend around the two lower nanosheet stack structures LNSS respectively at opposite sides of the lower gate cut structure LCT in the second horizontal direction (the Y direction), may be separated by the lower gate cut structure LCT. In other words, respective gates, i.e., lower gate electrodes LGL, of two lower transistors TRL, which are respectively formed in two lower nanosheet stack structures LNSS respectively at opposite sides of the lower gate cut structure LCT in the second horizontal direction (the Y direction), may not be connected to each other.

The upper gate cut structure UCT may be between two upper nanosheet stack structures UNSS adjacent to each other in the second horizontal direction (the Y direction) such that portions of the upper gate electrode UGL, which surround or extend around the two upper nanosheet stack structures UNSS respectively at opposite sides of the upper gate cut structure UCT in the second horizontal direction (the Y direction), may be separated by the upper gate cut structure UCT. In other words, respective gates, i.e., upper gate electrodes UGL, of two upper transistors TRU, which are respectively formed in two upper nanosheet stack structures UNSS respectively at opposite sides of the upper gate cut structure UCT in the second horizontal direction (the Y direction), may not be connected to each other.

The upper gate cut structure UCT on the lower gate cut structure LCT may be in contact with the lower gate cut structure LCT. Both the lower gate cut structure LCT and the upper gate cut structure UCT on the lower gate cut structure LCT may be between two nanosheet stack structures NSS, which are adjacent to each other in the second horizontal direction (the Y direction) and each include an upper nanosheet stack structure UNSS and a lower nanosheet stack structure LNSS, such that portions of the upper gate electrode UGL, which surround or extend around upper nanosheet stack structures UNSS respectively included in the two nanosheet stack structures NSS respectively at opposite sides of the structure of the lower gate cut structure LCT and the upper gate cut structure UCT on the lower gate cut structure LCT in the second horizontal direction (the Y direction), may be separated by the upper gate cut structure UCT and portions of the lower gate electrode LGL, which surround or extend around lower nanosheet stack structures LNSS respectively included in the two nanosheet stack structures NSS respectively at opposite sides of the structure of the lower gate cut structure LCT and the upper gate cut structure UCT on the lower gate cut structure LCT in the second horizontal direction (the Y direction), may be separated by the lower gate cut structure LCT. In other words, respective gates, i.e., the upper gate electrode UGL and the lower gate electrode LGL, of the upper transistor TRU and the lower transistor TRL, respectively formed in an upper nanosheet stack structure UNSS and a lower nanosheet stack structure LNSS, which are included in a nanosheet stack structure NSS on at least one side of the structure of the lower gate cut structure LCT and the upper gate cut structure UCT on the lower gate cut structure LCT in the second horizontal direction (the Y direction), may not be connected to each other with the intermediate insulating layer MDI and the lower gate cut structure LCT between the upper gate electrode UGL and the lower gate electrode LGL.

The coupling gate cut structure MCT may be between two nanosheet stack structures NSS, which are adjacent to each other in the second horizontal direction (the Y direction) and each include an upper nanosheet stack structure UNSS and a lower nanosheet stack structure LNSS, such that portions of the upper gate electrode UGL, which surround or extend around upper nanosheet stack structures UNSS respectively included in the two nanosheet stack structures NSS respectively at opposite sides of the coupling gate cut structure MCT in the second horizontal direction (the Y direction), may be separated by the coupling gate cut structure MCT and portions of the lower gate electrode LGL, which surround or extend around lower nanosheet stack structures LNSS respectively included in the two nanosheet stack structures NSS respectively at opposite sides of the coupling gate cut structure MCT in the second horizontal direction (the Y direction), may be separated by the coupling gate cut structure MCT. In other words, respective gates, i.e., upper gate electrodes UGL, of two upper transistors TRU transistors, which are respectively formed in the upper nanosheet stack structures UNSS respectively included in the two nanosheet stack structures NSS respectively at opposite sides of the coupling gate cut structure MCT in the second horizontal direction (the Y direction), may not be connected to each other, and respective gates, i.e., lower gate electrodes LGL, of two lower transistors TRL, which are respectively formed in the lower nanosheet stack structures LNSS respectively included in the two nanosheet stack structures NSS respectively at opposite sides of the coupling gate cut structure MCT in the second horizontal direction (the Y direction), may not be connected to each other.

A portion of the lower gate electrode LGL, which surrounds or extends around a lower nanosheet stack structure LNSS included in each of two nanosheet stack structures NSS respectively at opposite sides of the coupling gate cut structure MCT in the second horizontal direction (the Y direction), may be in contact with and electrically connected to a portion of the upper gate electrode UGL, which surrounds or extends around an upper nanosheet stack structure UNSS included in each of the two nanosheet stack structures NSS. In other words, respective gates, i.e., the upper gate electrode UGL and the lower gate electrode LGL, of the upper transistor TRU and the lower transistor TRL respectively formed in an upper nanosheet stack structure UNSS and a lower nanosheet stack structure LNSS, which are included in each of the two nanosheet stack structures NSS respectively at opposite sides of the coupling gate cut structure MCT in the second horizontal direction (the Y direction), may be connected to each other.

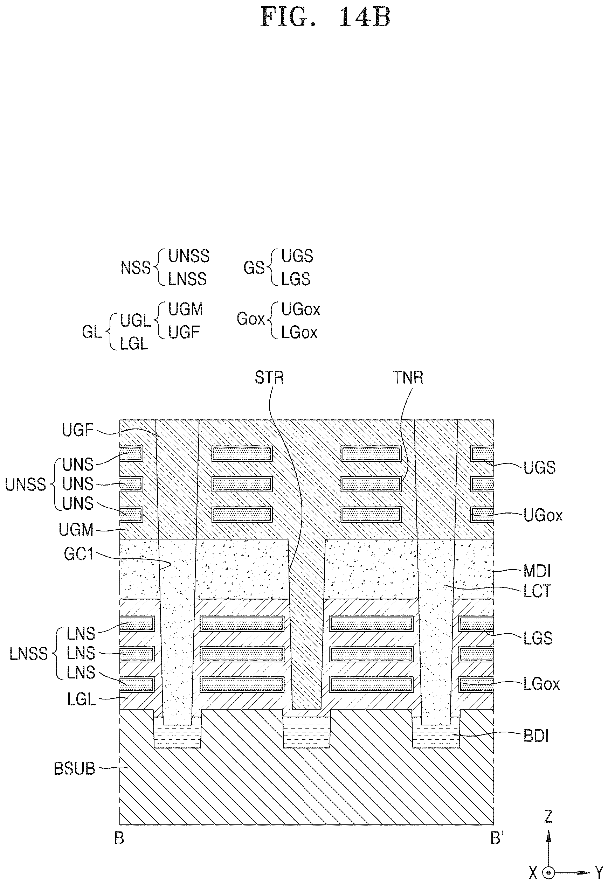

The connection extension GL-E of the upper gate electrode UGL may extend from a portion of the upper gate electrode UGL, which surrounds or extends around the upper nanosheet stack structure UNSS, along the side surface of the coupling gate cut structure MCT and may be connected to the lower gate electrode LGL. For example, the connection extension GL-E of the upper gate electrode UGL may extend between the coupling gate cut structure MCT and the intermediate insulating layer MDI and between the coupling gate cut structure MCT and the lower gate electrode LGL. The connection extension GL-E of the upper gate electrode UGL may correspond to a portion of the upper gate electrode UGL, which at least partially fills the isolation recess STR in FIG. 14B and remains without being removed in a process of forming the third gate cut space GC3.

The protrusion UGL-P of the upper gate electrode UGL may correspond to a portion of the upper gate electrode UGL, which protrudes or extends to the lower gate cut structure LCT from the portion of the upper gate electrode UGL surrounding or extending around the upper nanosheet stack structure UNSS. For example, the protrusion UGL-P of the upper gate electrode UGL may correspond to a portion of the upper gate electrode UGL, which protrudes or extends from a portion of the upper gate electrode UGL overlapping the intermediate insulating layer MDI in the vertical direction (the Z direction) so as to overlap the lower gate cut structure LCT. In some embodiments, the protrusion UGL-P of the upper gate electrode UGL may correspond to a portion of the upper filling gate layer UGF in FIG. 14B, which remains without being removed in a process of forming the second gate cut space GC2.

The width of the bottom surface of the upper gate cut structure UCT on the lower gate cut structure LCT may be less than the width of the top surface of the lower gate cut structure LCT. Accordingly, the lower gate cut structure LCT and the upper gate cut structure UCT on the lower gate cut structure LCT may have a step therebetween. A portion of the top surface of the lower gate cut structure LCT may be covered or overlapped by the bottom surface of the upper gate cut structure UCT, and another portion of the top surface of the lower gate cut structure LCT may be covered or overlapped by the protrusion UGL-P of the upper gate electrode UGL.

In some embodiments, respective protrusions UGL-P of a pair of upper gate electrodes UGL respectively at opposite sides of the upper gate cut structure UCT in the second horizontal direction (the Y direction) may have the same protrusion length as each other. The protrusion length of a protrusion UGL-P of an upper gate electrode UGL may refer to a horizontal width of the protrusion UGL-P, i.e., the upper filling gate layer UGF, or a horizontal width in the second horizontal direction (the Y direction) of a portion of the top surface of the lower gate cut structure LCT covered or overlapped by the protrusion UGL-P.

The distance between two nanosheet stack structures NSS, which are adjacent to each other in the second horizontal direction (the Y direction) and have the lower gate cut structure LCT, the upper gate cut structure UCT on the lower gate cut structure LCT, and the protrusion UGL-P of the upper gate electrode UGL therebetween, may be the same as the distance between two nanosheet stack structures NSS, which are adjacent to each other in the second horizontal direction (the Y direction) and have the coupling gate cut structure MCT and the connection extension GL-E of the upper gate electrode UGL.

Among a plurality of lower transistors TRL and upper transistors TRU of the stacked integrated circuit device 1, a lower transistor TRL and an upper transistor TRU above the lower transistor TRL, which are at each of the opposite sides of the coupling gate cut structure MCT, may be electrically connected to each other since the respective gates, i.e., the lower gate electrode LGL and the upper gate electrode UGL, of the lower transistor TRL and the upper transistor TRU are in contact with each other. Accordingly, the stacked integrated circuit device 1 may include at least a pair of cross-coupled transistors. Because the connection extension GL-E of the upper gate electrode UGL connects the upper transistor TRU to the lower transistor TRL and corresponds to a portion of the upper gate electrode UGL remaining, without being removed in a process of forming the third gate cut space GC3 and the coupling gate cut structure MCT at least partially filling the third gate cut space GC3, a separate patterning process is not required to form the connection extension GL-E of the upper gate electrode UGL. Accordingly, the stacked integrated circuit device 1 may have cross-coupled transistors formed with two contacted poly pitches (2CPP). In other words, the stacked integrated circuit device 1 may have cross-coupled transistors formed with the double of a pitch that is the sum of the horizontal width of each of a plurality of gate electrodes GL in the first horizontal direction (the X direction) and the distance between two gate electrodes GL adjacent to each other in the first horizontal direction (the X direction). Accordingly, the scaling-down of the stacked integrated circuit device 1 may be possible.

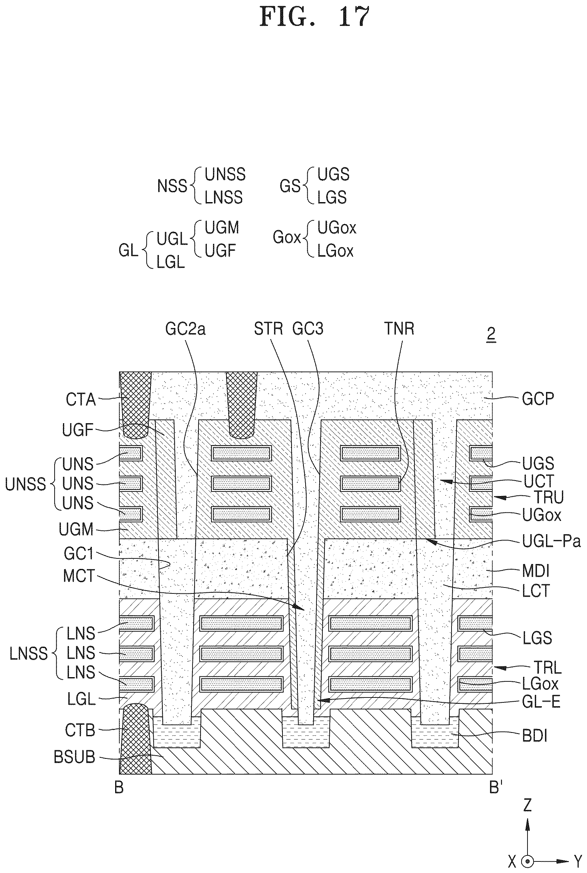

FIG. 17 is a cross-sectional view illustrating a stacked integrated circuit device 2 according to embodiments. In detail, FIG. 17 is a cross-sectional view taken along a position corresponding to line B-B' in FIG. 2. A cross-sectional view of the stacked integrated circuit device 2 of FIG. 17, taken along a position corresponding to line A-A' in FIG. 2, may be substantially the same as FIG. 16A. A cross-sectional view of the stacked integrated circuit device 2 of FIG. 17, taken along a position corresponding to line C-C' in FIG. 2, may be substantially the same as FIG. 16C.

Referring to FIGS. 16A, 16C, and 17, the stacked integrated circuit device 2 may include a lower insulating layer BDI, a plurality of nanosheet stack structures NSS each including a lower nanosheet stack structure LNSS on the lower insulating layer BDI and an upper nanosheet stack structure UNSS on the lower nanosheet stack structure LNSS, an intermediate insulating layer MDI between the lower nanosheet stack structure LNSS and the upper nanosheet stack structure UNSS, a gate electrode GL including a lower gate electrode LGL surrounding or extending around the lower nanosheet stack structure LNSS and an upper gate electrode UGL surrounding or extending around the upper nanosheet stack structure UNSS, a first contact plug CTA connected to an upper source/drain region SDU, a second contact plug CTB connected to a lower source/drain region SDL, a lower gate cut structure LCT between two lower nanosheet stack structures LNSS adjacent to each other in the second horizontal direction (the Y direction), an upper gate cut structure UCT on the lower gate cut structure LCT and between two upper nanosheet stack structures UNSS adjacent to each other in the second horizontal direction (the Y direction), and a coupling gate cut structure MCT between two nanosheet stack structures NSS adjacent to each other in the second horizontal direction (the Y direction), wherein two coupling gate cut structures MCT may be separated by at least one nanosheet stack structure NSS and a structure of the lower gate cut structure LCT and the upper gate cut structure UCT on the lower gate cut structure LCT. The upper gate electrode UGL may include a connection extension GL-E and a protrusion UGL-Pa. The lower gate cut structure LCT may at least partially fill a lower portion of the first gate cut space GC1, the upper gate cut structure UCT may at least partially fill the second gate cut space GC2, and the coupling gate cut structure MCT may at least partially fill the third gate cut space GC3. The protrusion UGL-Pa of the upper gate electrode UGL and the upper gate cut structure UCT may at least partially fill an upper portion of the first gate cut space GC1.

In some embodiments, the protrusion UGL-Pa of the upper gate electrode UGL may be arranged at one side of the upper gate cut structure UCT but not at an opposite side thereof in the second horizontal direction (the Y direction). For example, a portion of the top surface of the lower gate cut structure LCT, which is at one side in the second horizontal direction (the Y direction), may be covered or overlapped by the bottom surface of the protrusion UGL-Pa of the upper gate electrode UGL, and the other portion of the top surface of the lower gate cut structure LCT, which is at the opposite side in the second horizontal direction (the Y direction), may be covered or overlapped by the bottom surface of the upper gate cut structure UCT.

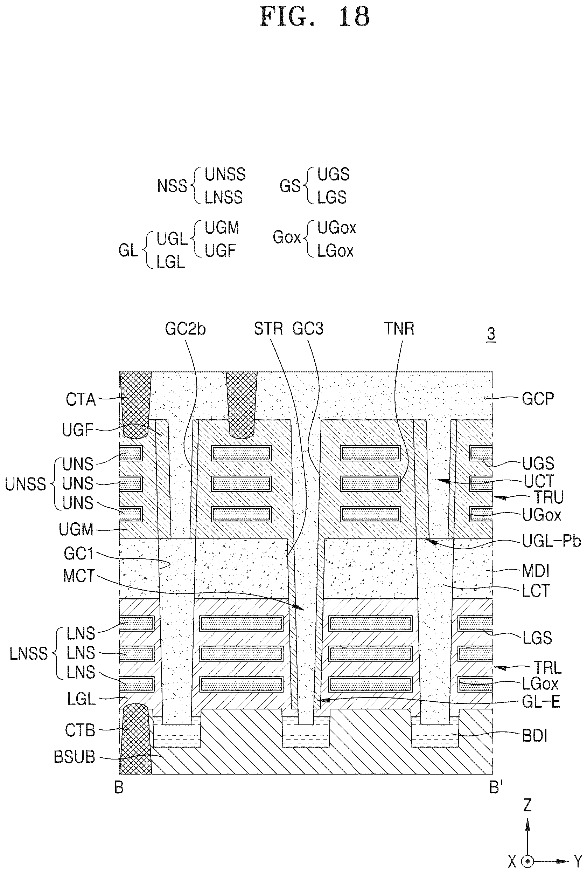

FIG. 18 is a cross-sectional view illustrating a stacked integrated circuit device 3 according to embodiments. In detail, FIG. 18 is a cross-sectional view taken along a position corresponding to line B-B' in FIG. 2. A cross-sectional view of the stacked integrated circuit device 3 of FIG. 18, taken along a position corresponding to line A-A' in FIG. 2, may be substantially the same as FIG. 16A. A cross-sectional view of the stacked integrated circuit device 3 of FIG. 18, taken along a position corresponding to line C-C' in FIG. 2, may be substantially the same as FIG. 16C.

Referring to FIGS. 16A, 16C, and 18, the stacked integrated circuit device 3 may include a lower insulating layer BDI, a plurality of nanosheet stack structures NSS each including a lower nanosheet stack structure LNSS on the lower insulating layer BDI and an upper nanosheet stack structure UNSS on the lower nanosheet stack structure LNSS, an intermediate insulating layer MDI between the lower nanosheet stack structure LNSS and the upper nanosheet stack structure UNSS, a gate electrode GL including a lower gate electrode LGL extending around or surrounding the lower nanosheet stack structure LNSS and an upper gate electrode UGL surrounding or extending around the upper nanosheet stack structure UNSS, a first contact plug CTA connected to an upper source/drain region SDU, a second contact plug CTB connected to a lower source/drain region SDL, a lower gate cut structure LCT between two lower nanosheet stack structures LNSS adjacent to each other in the second horizontal direction (the Y direction), an upper gate cut structure UCT on the lower gate cut structure LCT and between two upper nanosheet stack structures UNSS adjacent to each other in the second horizontal direction (the Y direction), and a coupling gate cut structure MCT between two nanosheet stack structures NSS adjacent to each other in the second horizontal direction (the Y direction), wherein two coupling gate cut structures MCT may be separated by at least one nanosheet stack structure NSS and a structure of the lower gate cut structure LCT and the upper gate cut structure UCT on the lower gate cut structure LCT. The upper gate electrode UGL may include a connection extension GL-E and a protrusion UGL-Pb. The lower gate cut structure LCT may at least partially fill a lower portion of the first gate cut space GC1, the upper gate cut structure UCT may at least partially fill the second gate cut space GC2, and the coupling gate cut structure MCT may at least partially fill the third gate cut space GC3. The protrusion UGL-Pb of the upper gate electrode UGL and the upper gate cut structure UCT may at least partially fill an upper portion of the first gate cut space GC1.

In some embodiments, respective protrusions UGL-Pb of a pair of upper gate electrodes UGL respectively at opposite sides of the upper gate cut structure UCT in the second horizontal direction (the Y direction) may have different protrusion or extension lengths from each other. For example, the protrusion length of a protrusion UGL-Pb of the upper gate electrode UGL at one side of the upper gate cut structure UCT in the second horizontal direction (the Y direction) may be greater than the protrusion length of a protrusion UGL-Pb of the upper gate electrode UGL at the opposite side of the upper gate cut structure UCT in the second horizontal direction (the Y direction).

## Claims

1. A stacked integrated circuit device (100) comprising:
a plurality of nanosheet stack structures (NSS) spaced apart from each other in a first direction (X) and a second direction (Y) perpendicular to the first direction (X), the plurality of nanosheet stack structures (NSS) each comprising a lower nanosheet stack structure (LNSS) and an upper nanosheet stack structure (UNSS) on the lower nanosheet stack structure (LNSS);
a gate separator (MDI) between the lower nanosheet stack structure (LNSS) and the upper nanosheet stack structure (UNSS) of each of the plurality of nanosheet stack structures (NSS);
a lower gate electrode (LGL) extending around the lower nanosheet stack structure (LNSS) of each of the plurality of nanosheet stack structures (NSS);
a first upper gate electrode (UGL) extending around the upper nanosheet stack structure (UNSS) of each of the plurality of nanosheet stack structures (NSS);
a lower gate cut structure (LCT) and an upper gate cut structure (UCT) on the lower gate cut structure (LCT), the lower gate cut structure (LCT) being between a first pair of lower nanosheet stack structures (LNSS) of a first pair of nanosheet stack structures (NSS) adjacent to each other in the second direction (Y) among the plurality of nanosheet stack structures (NSS), and the upper gate cut structure (UCT) being between a first pair of upper nanosheet stack structures (UNSS) of the first pair of nanosheet stack structures (NSS); and
a coupling gate cut structure (MCT) between a second pair of nanosheet stack structures (NSS) adjacent to each other in the second direction (Y) among the plurality of nanosheet stack structures (NSS),
wherein the first upper gate electrode (UGL) extends along a side surface of the coupling gate cut structure (MCT) and is electrically connected to the lower gate electrode (LGL).

2. The stacked integrated circuit device (100) of claim 1, wherein:
a portion of the lower gate electrode (LGL) on at least one side of the lower gate cut structure (LCT) is separated from and is not electrically connected to the first upper gate electrode (UGL).

3. The stacked integrated circuit device (100) of claim 1 or 2, wherein a width of a top surface of the lower gate cut structure (LCT) in the second direction (Y) is greater than a width of a bottom surface of the upper gate cut structure (UCT) in the second direction (Y).

4. The stacked integrated circuit device (100) of claim 3, wherein the first upper gate electrode (UGL) comprises a first protrusion (UGL-P) extending from a portion of the first upper gate electrode (UGL) that overlaps the gate separator (MDI) and the lower gate cut structure (LCT), optionally a first portion of a top surface of the lower gate cut structure (LCT), in a third direction (Z) that is perpendicular to the first direction (X) and the second direction (Y).

5. The stacked integrated circuit device (100) of claim 4, wherein a first portion of the top surface of the lower gate cut structure (LCT) overlaps the bottom surface of the upper gate cut structure (UCT) in the third direction (Z), and a second portion of the top surface of the lower gate cut structure (LCT) overlaps a bottom surface of the first protrusion (UGL-P) in the third direction (Z).

6. The stacked integrated circuit device of claim 4, wherein:
a first side surface of the lower gate cut structure (LCT) at least partially overlaps a bottom surface of the first protrusion (UGL-P) of the first upper gate electrode (UG) in the second direction (Y), and
a second side surface of the lower gate cut structure (LCT) that is opposite to the first side surface of the lower gate cut structure (LCT) at least partially overlaps a bottom surface of the upper gate cut structure (UCT) in the second direction (Y).

7. The stacked integrated circuit device (100) of claim 4 or 5, wherein the first protrusion of the first upper gate electrode and a second protrusion of a second upper gate electrode are on opposite sides of the upper gate cut structure in the second direction.

8. The stacked integrated circuit device (100) of claim 4 or 5, wherein a length of the first protrusion (UGL-P) in the second direction (Y) and a length of a second protrusion (UGL-Pa, UGL-Pb) of a second upper gate electrode (UGL) in the second direction (Y) are equal to each other, and wherein the first protrusion (UGL-P) and the second protrusion (UGL-Pa, UGL-Pb) are on opposite sides of the upper gate cut structure (UCT).

9. The stacked integrated circuit device (100) of claim 4 or 5, wherein a length of the first protrusion (UGL-P) in the second direction (Y) and a length of a second protrusion (UGL-Pa, UGL-Pb) of a second upper gate electrode (UGL) in the second direction (Y) are different from each other, and wherein the first protrusion (UGL-P) and the second protrusion (UGL-Pa, UGL-Pb) are on opposite sides of the upper gate cut structure (UCT).

10. The stacked integrated circuit device (100) of any one of claims 4 to 9, wherein the first protrusion (UGL-P) of the first upper gate electrode (UGL) is on a first side of the upper gate cut structure (UCT) in the second direction (Y) and is not on a second side of the upper gate cut structure (UCT) that is opposite to the first side of the upper gate cut structure (UCT).

11. The stacked integrated circuit device (100) of any one of claims 1 to 10, wherein a number of lower nanosheets (LNS) of the lower nanosheet stack structure (LNSS) is greater than a number of upper nanosheets (UNS) of the upper nanosheet stack structure (UNSS).

12. The stacked integrated circuit device (100) of any one of claims 1 to 11, wherein:
the lower nanosheet stack structure (LNSS) comprises a plurality of lower nanosheets (LNS) spaced apart from each other in a third direction (Z) that is perpendicular to the first direction (X) and the second direction (Y),
the upper nanosheet stack structure (UNSS) includes a plurality of upper nanosheets (UNS) spaced apart from each other in the third direction (Z), and
a width of each of the plurality of lower nanosheets (LNS) in the second direction (Y) is greater than a width of each of the plurality of upper nanosheets (UNS) in the second direction (Y).

13. The stacked integrated circuit device (100) of any one of claims 1 to 12, further comprising wherein the first upper gate electrode (UGL) comprises a connection extension (GL-E) extending along a side surface of the coupling gate cut structure (MCT) and is electrically connected to the lower gate electrode (LGL).

14. The stacked integrated circuit device (100) of claim 13, wherein the connection extension (GL-E) of the first upper gate electrode (UGL) extends between the coupling gate cut structure (MCT) and the gate separator (MDI) and between the coupling gate cut structure (MCT) and the lower gate electrode (LGL).

15. The stacked integrated circuit device of claim 1, wherein a portion of the lower gate electrode (LGL) on at least one side of the lower gate cut structure (LCT) is separated, by the gate separator (MDI) and the lower gate cut structure (LCT), from the upper gate electrode (UGL).
